# EUROPEAN PATENT APPLICATION

(11) **EP 3 498 778 A1**
(43) Date of publication of application: **19.06.2019**
(21) Application number: 17839357.5
(22) Date of filing: 04.08.2017
(51) Int. Cl.: C08L 83/04, C08J 5/00, C08K 3/00, H01L 21/56, H01L 33/60

(54) **CURABLE PARTICULATE SILICONE COMPOSITION, OPTICALLY REFLECTIVE MATERIAL COMPRISING CURABLE PARTICULATE SILICONE COMPOSITION, AND PRODUCTION METHOD FOR OPTICALLY REFLECTIVE MATERIAL COMPRISING CURABLE PARTICULATE SILICONE COMPOSITION**

(30) Priority: 08.08.2016 JP 2016155383
(71) Applicant: Dow Corning Toray Co., Ltd., Tokyo 100-0004 (JP)
(72) Inventor: YAMAZAKI Ryosuke, Ichihara-shi Chiba 299-0108 (JP)
(74) Representative: Murgitroyd & Company
(86) International application number: PCT/JP2017/028384
(87) International publication number: WO 2018/030286

(57) **Abstract**

[Problem] Provided are a curable particulate silicone composition having hot-melt properties, excellent handling workability and curing characteristics, high light reflectance in the visible wavelength region, and excellent flexibility and toughness at a temperature of from room temperature to a high temperature of about 150°C., and use thereof.

[Resolution Means] A curable particulate silicone composition, includes (A) hot-melt silicone fine particles having a softening point of 30°C. or higher and having a hydrosilylation reactive group and/or a radical reactive group; (B) an inorganic filler substantially free of coarse particles having an average particle diameter of 5 µm or more (fine particles); and (C) a curing agent, wherein when cured, the curable particulate silicone composition provides a cured product that has: a storage modulus (G') at 25°C. of 2000 MPa or less, and a storage modulus (G') at 150°C. of 100 MPa or less, and a spectral reflectance of 90% or more at a wavelength of 450 nm, preferably 700 nm, at a thickness of 100 µm, and use thereof.

## Description

### TECHNICAL FIELD

The present invention relates to a curable particulate silicone composition and pellet molded from the curable particulate silicone composition. Further, the present invention relates to a cured product using the curable particulate silicone composition or a pellet, a sheet, a molding method of the cured product, a light reflecting material including the cured product, and a semiconductor device including the cured product.

### BACKGROUND ART

Curable silicone compositions are utilized in a wide range of industrial fields because they are cured to form cured products having excellent heat resistance, cold resistance, electrical insulation, weather resistance, water repellency, and transparency. The cured product of such a curable silicone composition is also suitable as an optical material because it is hardly discolored as compared with other organic materials, and physical properties are less deteriorated.

The present applicant has proposed, in Patent Document 1 and Patent Document 2, a so-called hot melt curable particulate silicone composition and a reactive silicone composition. However, cured products obtained by curing these silicone compositions may have insufficient flexibility and toughness, especially at a temperature of from room temperature to a high temperature of about 150°C. In addition, these documents hardly describe the wavelength dependence of light reflectance in the visible light region, and do not disclose materials having high light reflectance in thin films.

In addition, the present applicant has proposed a liquid (pasty) curable silicone composition in Patent Document 3 and Patent Document 4. However, these liquid or pasty curable silicone compositions have insufficient handling workability, curing characteristics, and gap filling properties, and also have insufficient flexibility and toughness of the cured product at a temperature of from room temperature to a high temperature of about 150°C., and in particular, insufficient flexibility of the cured product may cause problems of warpage and breakage.

On the other hand, Patent Document 5 and Patent Document 6 disclose a hot-melt curable composition using a mixed filler containing coarse particles, but the storage modulus of the cured product at room temperature is extremely high (e.g., 5000 MPa or more in Patent Document 5) and the flexibility is poor, so that it is difficult to apply the composition to an application which is subjected to deformation or bending at room temperature. In addition, since warpage after integrally molding with the lead frame is suppressed by reducing the coefficient of linear expansion due to high filler filling, a large amount of white pigment cannot be added. Therefore, these inventions have a problem that a high reflectance in a thin film cannot be achieved.

### Prior Art Documents

### Patent Documents

[Patent Document 1] PCT/JP2016/000959
[Patent Document 2] JP 2014-009322 A
[Patent Document 3] WO 2016/038836
[Patent Document 4] JP 2013-076050 A
[Patent Document 5] JP 2013-221075 A
[Patent Document 6] WO 2013/051600

### SUMMARY OF THE INVENTION

### Problems to be Solved by the Invention

An object of the present invention is to provide a curable particulate silicone composition having hot-melt properties, excellent handling workability and curing characteristics, high light reflectance in the visible wavelength region, and excellent flexibility and toughness at a temperature of from room temperature to a high temperature of about 150°C., and a pellet or the like formed by molding the curable particulate silicone composition. Another object of the present invention is to provide a light reflecting material composed of such a curable particulate silicone composition and a cured product such as pellets, an optical semiconductor device having the cured product, and a molding method of the cured product.

### Means for Solving the Problems

The curable particulate silicone composition of the present invention includes:
(A) hot-melt silicone fine particles having a softening point of 30°C. or higher and having a hydrosilylation reactive group and/or a radical reactive group;
(B) an inorganic filler substantially free of coarse particles having an average particle diameter of 5 µm or more (fine particles); and
(C) a curing agent,
wherein when cured, the curable particulate silicone composition provides a cured product that has:
a storage modulus (G') at 25°C. of 2000 MPa or less, and
a storage modulus (G') at 150°C. of 100 MPa or less, and
a light reflectance of 90% or more at a wavelength of 450 nm at a thickness of 100 µm. Preferably, the cured product has a light reflectance of 90% or more at a wavelength of 700 nm at a thickness of 100 µm.

Component (B) is preferably a filler that does not have a softening point or does not soften below the softening point of component (A). In addition, component (B) of the present invention substantially does not contain coarse particles having an average particle diameter of 5 µm or more, and it is particularly preferable that 90 mass% or more of component (B) is titanium oxide fine particle having an average particle diameter of 0.5 µm or less (B1). In the present invention, most preferably, component (B) consists essentially of (B1) titanium oxide fine particles having an average particle diameter of 0.5 µm or less.

Component (A) is preferably silicone fine particles including (A₁) a resinous organopolysiloxane, (A₂) an organopolysiloxane crosslinked product obtained by partially crosslinking at least one organopolysiloxane, (A₃) a block copolymer composed of a resinous organosiloxane block and a chained organosiloxane block, or a mixture of at least two of these. In addition, it is particularly preferable that component (A) is true spherical silicone fine particles in which 10 mol% or more of the silicon atom-bonded organic groups in component (A) is an aryl group and the average primary particle diameter thereof is 1 to 500 µm, and such true spherical silicone fine particles are preferably obtained by use of a spray dryer or the like. It is particularly preferable that component (B) is an inorganic filler having a particle diameter smaller than that of component (A).

The content of component (B) is preferably in the range of 10 to 2000 parts by mass, particularly preferably in the range of 10 to 900 parts by mass, with regard to 100 parts by mass of component (A). Component (B) can be blended in a quantitative range of 50 mass% or more, 60 mass% or more, and 70 mass% or more of the entire composition, and is suitable.

The curable particulate silicone composition of the present invention is preferably in the form of pellets or sheets.

The curable particulate silicone composition of the present invention can be used in the form of a cured product, and can be used as a light reflecting material and a member of an optical semiconductor device. The cured product of the present invention has a high light reflectance at a visible wavelength and a small wavelength dependence of the light reflectance. Specifically, for the cured product of the present invention, it is preferable that the light reflectance (ρ₄₅₀) at a wavelength of 450 nm and the light reflectance (ρ₇₀₀) at a wavelength of 700 nm at a thickness of 100 µm are both 90% or more, and
the differences in the respective light reflectance expressed as (ρ₇₀₀ /ρ₄₅₀)*100(%) are less than 10%.

The curable particulate silicone composition of the present invention and the cured product thereof can be used in an optical semiconductor device, and an optical semiconductor device in which a light reflecting material is formed by the cured product is provided. In particular, according to the present invention, a chip scale package type optical semiconductor device in which the wall thickness of the light reflecting material is reduced is preferably provided.

The method of molding the curable particulate silicone composition of the present invention comprises at least the following steps.
(I) a step of heating and melting the curable particulate silicone composition according to any one of claims 1 to 8 to the softening point of component (A) or higher;
(II) a step of injecting the curable silicone composition obtained in step (I) into a mold or a step of distributing the curable silicone composition obtained in step (I) to a mold by clamping; and
(III) a step of curing the curable silicone composition injected in step (II).
The above molding method includes transfer molding, compression molding, or injection molding, and the curable particulate silicone composition of the present invention is suitably used as a material for these molding techniques.

### Effects of the Invention

The curable particulate silicone composition of the present invention, including in the form of pellets, has hot-melt properties, excellent handling workability and curing characteristics, has a high light reflectance in the visible wavelength region, and provides a cured product having excellent flexibility and toughness at a temperature of from room temperature to a high temperature of about 150°C. In addition, the cured product of the present invention is useful as a light reflecting material and a member of an optical semiconductor device, and by using the molding method of the present invention, these cured products can be efficiently produced in accordance with applications.

### MODE FOR CARRYING OUT THE INVENTION

### Curable Particulate Silicone Composition

The curable particulate silicone composition of the present invention is characterized by containing the following components (A) to (C) and having flexibility from room temperature to a high temperature by curing, and providing a cured product having a high light reflectance in the visible wavelength region.
The curable particulate silicone composition contains
(A) hot-melt silicone fine particles having a softening point of 30°C. or higher and having a hydrosilylation reactive group and/or a radical reactive group;
(B) an inorganic filler substantially free of coarse particles having an average particle diameter of 5 µm or more (fine particles); and
(C) a curing agent.

Hereinafter, each component and optional component of the composition will be described.

Component (A) is hot-melt silicone fine particles having a softening point of 30°C. or higher and having a hydrosilylation reactive group and/or a radical reactive group, and provides good hot-melt properties to the composition and is cured by the curing agent (C).

Examples of the hydrosilylation reactive group in component (A) include an alkenyl group having 2 to 20 carbon atoms such as vinyl groups, allyl groups, butenyl groups, pentenyl groups, hexenyl groups, heptenyl groups, octenyl groups, nonenyl groups, decenyl groups, undecenyl groups, and dodecenyl groups, and a silicon atom bonded hydrogen atom. As the hydrosilylation reactive group, an alkenyl group is preferable. The alkenyl group may be linear or branched, and is preferably a vinyl group or a hexenyl group. Component (A) preferably has at least two hydrosilylation reactive groups in one molecule.

Examples of the group bonded to a silicon atom other than the hydrosilylation reactive group in component (A) include an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, an alkoxy group, and a hydroxyl group. Specific examples thereof include alkyl groups such as methyl, ethyl, propyl, butyl, pentyl, hexyl, heptyl, octyl, nonyl, decyl, undecyl, and dodecyl; aryl groups such as phenyl, tolyl, xylyl, naphthyl, anthracenyl, phenanthryl, and pyrenyl; aralkyl groups such as phenethyl and phenylpropyl; groups in which a part or all of the hydrogen atoms bonded to these groups are substituted with a halogen atom such as a chlorine atom and a bromine atom; and alkoxy groups such as methoxy, ethoxy, and propoxy. In particular, a phenyl group and a hydroxyl group are preferable.

Examples of radical reactive groups in component (A) include alkyl groups having 1 to 20 carbon atoms, such as methyl, ethyl, propyl, butyl, pentyl, hexyl, heptyl, octyl, nonyl, decyl, undecyl, and dodecyl; alkenyl groups having 2 to 20 carbon atoms, such as vinyl, allyl, butenyl, pentenyl, hexenyl, heptenyl, octenyl, nonenyl, decenyl, undecenyl, and dodecenyl; acryl-containing groups such as 3-acryloxypropyl and 4-acryloxybutyl; methacryl-containing groups such as 3-methacryloxypropyl and 4-methacryloxybutyl; and a silicon atom bonded hydrogen atom. As the radical reactive group, an alkenyl group is preferable. The alkenyl group may be linear or branched, and is preferably a vinyl group or a hexenyl group. Component (A) preferably has at least two radical reactive groups in one molecule.

Examples of the group bonded to a silicon atom other than the radical reactive group in component (A) include a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, an alkoxy group, and a hydroxyl group, and the same groups as those described above are exemplified. In particular, a phenyl group and a hydroxyl group are preferable. In particular, in component (A), it is preferable that 10 mol% or more of the total organic groups in the molecule be an aryl group, in particular, a phenyl group.

Component (A) itself has hot-melt properties and is cured by the curing agent (C) described later. Such component (A) is preferably silicone fine particles including (A₁) a resinous organopolysiloxane, (A₂) an organopolysiloxane crosslinked product obtained by crosslinking at least one organopolysiloxane, (A₃) a block copolymer composed of a resinous organosiloxane block and a chained organosiloxane block, or a mixture of at least two of these.

Component (A₁) is a resinous organopolysiloxane having a hydrosilylation reactive group and/or a radical reactive group, and is preferably a hot-melt resinous organopolysiloxane having a large number of T-units or Q-units and an aryl group. Examples of such component (A₁) include MQ resins, MDQ resins, MTQ resins, MDTQ resins, TD resins, TQ resins, and TDQ resins comprised of an arbitrary combination of triorganosiloxy units (M-units) (organo groups are methyl groups only, methyl groups and vinyl groups or phenyl groups), diorganosiloxy units (D-units) (organo groups are methyl groups only, methyl groups and vinyl groups or phenyl groups), monoorganosiloxy units (T-units) (organo groups are methyl groups, vinyl groups, or phenyl groups), and siloxy units (Q-units). It is preferable that the (A 1) component has at least two hydrosilylation reactive groups and/or radical reactive groups in the molecule, and 10 mol % or more of the total organic groups in the molecule is an aryl group, particularly, a phenyl group.

In addition, since the (A₂) component is formed by crosslinking at least one organopolysiloxane, cracks are hardly generated when the component is cured by the (C) curing agent, and the curing shrinkage can be reduced. Here, "crosslinking" means linking the organopolysiloxane as a raw material by a hydrosilylation reaction, a condensation reaction, a radical reaction, a high energy ray reaction, or the like. Examples of the hydrosilylation reactive group and the radical reactive group (including the high energy ray reactive group) include the same groups as those described above, and examples of the condensation reactive group include a hydroxyl group, an alkoxy group, and an acyloxy group.

The unit constituting component (A₂) is not limited, and siloxane units and siloxane units containing silalkylene groups are exemplified, and it is preferable to have a resinous polysiloxane unit and a chained polysiloxane unit in the same molecule because they impart adequate hardness and mechanical strength to the obtained cured product. That is, component (A₂) is preferably a crosslinked product of a resinous organopolysiloxane and a chained organopolysiloxane (including a linear or branched chain organopolysiloxane). By introducing the resinous organopolysiloxane structure-chained organopolysiloxane structure into component (A₂), component (A₂) exhibits good hot-melt properties, and the curing agent (C) exhibits good curing properties.

Component (A₂) is any one of the following (1) to (3):
(1) One obtained by linking a resinous organopolysiloxane structure-chain organopolysiloxane structure in the molecule by an alkylene linkage via a hydrosilylation reaction of an organopolysiloxane having at least two alkenyl groups in one molecule and an organopolysiloxane having at least two silicon atom bonded hydrogen atoms in one molecule;
(2) One obtained by linking a resinous organopolysiloxane structure-chain organopolysiloxane structure in the molecule by a siloxane linkage or an alkylene linkage via a radical reaction of an organic peroxide of at least two organopolysiloxanes having at least two radical reactive groups in one molecule;
(3) One obtained by linking a resinous organopolysiloxane structure-chain organopolysiloxane structure in the molecule by a siloxane (-Si-O-Si-) linkage via a condensation reaction of at least two organopolysiloxanes.
Such component (A₂) has a structure in which organopolysiloxane moieties of the resin structure-chain structure are linked by an alkylene group or new siloxane linkage, so that hot-melt properties are remarkably improved.

In the above (1) and (2), as the alkylene group contained in component (A₂), an alkenyl group having 2 to 20 carbon atoms such as an ethylene group, a propylene group, a butylene group, a pentylene group, a hexylene group, or the like is exemplified, and these groups may be linear or branched, and are preferably an ethylene group or a hexylene group.

The crosslinked products of resinous organopolysiloxanes and chain organopolysiloxanes, including linear or branched chain organopolysiloxanes, are composed of, for example, the following siloxane units and siloxane units containing silalkylene groups:
M-units: siloxane units represented by R¹R²₂SiO_{1/2};
D-units: siloxane units represented by R¹R²SiO_{2/2};
R³M/R³D-units: at least one siloxane unit selected from a silalkylene group containing siloxane unit represented by R³_{1/2}R²₂SiO_{1/2} and a silalkylene group containing siloxane unit represented by R³_{1/2}R²SiO_{2/2}; and
T/Q-units: at least one siloxane unit selected from a siloxane unit represented by R²SiCO_{3/2} and a siloxane unit represented by SiO_{4/2}.

In the formulae, each R¹ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. R¹ is preferably a methyl group, a vinyl group, or a phenyl group. However, it is preferable that at least two R¹ of all siloxane units are alkenyl groups.

In addition, in the formulae, each R² is independently an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, or an aralkyl group having 7 to 20 carbon atoms, and the same groups as the R¹ are exemplified. R² is preferably a methyl group or a phenyl group.

In the formulae, R³ is a linear or branched alkylene group having 2 to 20 carbon atoms bonded to a silicon atom in other siloxane units. As the alkylene group, the same groups as described above are exemplified, and an ethylene group and a hexylene group are preferable.

The M-unit is a siloxane unit constituting the terminal of component (A₂), and the D-unit is a siloxane unit constituting a linear polysiloxane structure. Note that it is preferable that an alkenyl group is present on the M-unit or the D-unit, in particular, the M-unit. On the other hand, the R³M-unit and the R³D-unit are siloxane units bonded to a silicon atom in another siloxane unit via a silalkylene linkage and bonded to a silicon atom in another siloxane unit via an oxygen atom. The T/Q-unit is a branched siloxane unit which gives a resinous structure to the polysiloxane, and component (A₂) preferably contains a siloxane unit represented by R²SiO_{3/2} and/or a siloxane unit represented by SiO_{4/2}. In particular, since the hot-melt properties of component (A₂) is improved and the content of the aryl group in component (A₂) is adjusted, it is preferable that component (A₂) contains a siloxane unit represented by R²SiO_{3/2}, and in particular, it is preferable that component (A₂) contains a siloxane unit in which R² is a phenyl group.

The R³M/R³D-unit is one of the characteristic structures of component (A₂), and represents a structure in which silicon atoms are crosslinked via the alkylene group of R³. Specifically, the R³M/R³D-unit is at least one siloxane unit selected from an alkylene group-containing siloxane unit represented by R³_{1/2}R²₂SiO_{1/2} and an alkylene group-containing siloxane unit represented by R³_{1/2}R²SiO_{2/2}, and at least two of all siloxane units constituting component (A₂) are preferably these alkylene group-containing siloxane units. The preferred form of linkage between siloxane units having alkylene groups of R³ is as described above, and the number of R³ between two alkylene group-containing siloxane units is expressed as the linkage number "1/2" as is the number of oxygens and the like in the M-units. Assuming that the number of R³ is 1, at least one or more selected from the structural units of siloxanes represented by [O_{1/2}R²₂SiR₃SiR²₂O_{1/2}], [O_{1/2}R²₂SiR³SiR²CO_{2/2}], and [O_{2/2}R²SiR³SiR²O_{2/2}] is contained in component (A₂), and each oxygen atom (O) is bonded to a silicon atom contained in the M, D, and T/Q-units. With such a structure, component (A₂) can relatively easily design a structure having a chain polysiloxane structure comprised of D-units and a resinous polysiloxane structure containing T/Q-units in the molecule, and the component is remarkably excellent in physical properties.

In the above (1), the component can be obtained by hydrosilylation reaction of an organopolysiloxane having at least two alkenyl groups in one molecule and an organopolysiloxane having at least two silicon atom bonded hydrogen atoms in one molecule at a reaction ratio of [number of moles of alkenyl groups]/[number of moles of silicon atom bonded hydrogen atoms]>1.

In the above (2), the component can be obtained by radical reaction of at least two organopolysiloxanes having at least two radical reactive groups in one molecule with an organic peroxide in an amount which is insufficient for all radical reactive groups in the system to react.

In the above (1) and (2), component (A₂) is obtained by subjecting an organopolysiloxane having a resinous siloxane structure and an organopolysiloxane having a chain siloxane structure to a hydrosilylation reaction or a radical reaction.

For example, component (A₂) is an organopolysiloxane obtained by reacting component (A^{R}) and component (A^{L}) at a ratio designed so that a hydrosilylation reactive group and/or a radical reactive group in component (A^{R}) or component (A^{L}) remains after the reaction, wherein component (A^{R}) is at least one resinous organopolysiloxane that contains a siloxane unit represented by formula R²SiO_{3/2} (wherein R² is the same group as defined above) and/or SiO_{4/2} and has an alkenyl group of 2 to 20 carbon atoms or a silicon bonded hydrogen atom or a radical reactive group, and component (A^{L}) is at least one chain organopolysiloxane that contains a siloxane unit represented by R²₂SiO_{2/2} in the molecule (wherein R² is the same group as defined above) and has an alkenyl group of 2 to 20 carbon atoms or a silicon atom bonded hydrogen atom, which is a group capable of hydrosilylation reaction or radical reaction with the component (A^{R}).

In the above (1), when at least a part of component (A^{R}) is a resinous organopolysiloxane having an alkenyl group of 2 to 20 carbon atoms, it is preferable that at least a part of component (A^{L}) is a chain organopolysiloxane having a silicon atom bonded hydrogen atom.

Similarly, when at least a part of component (A^{R}) is a resinous organopolysiloxane having a silicon atom bonded hydrogen atom, it is preferable that at least a part of component (A^{L}) is a chain organopolysiloxane having an alkenyl group of 2 to 20 carbon atoms.

Such component (A₂) is preferably one obtained by radical reaction of component (a₁): an organopolysiloxane comprised of the following component (a₁₋₁) and/or the following component (a₁₋₂) and having at least two alkenyl groups of 2 to 20 carbon atoms, or one obtained by hydrosilylation reaction of component (a₁) with (a₂) organohydrogenpolysiloxane in the presence of a hydrosilylation reaction catalyst in an amount such that the molar ratio of the silicon atom bonded hydrogen atoms in the component (a₂) to the alkenyl groups having 2 to 20 carbon atoms contained in the component (a₁) is from 0.2 to 0.7 mol.

Component (a₁₋₁) is polysiloxanes with relatively large amounts of branching units, and organopolysiloxanes having at least two alkenyl groups in one molecule, expressed by the average unit formula:

(R⁴₃SiO_{1/2})ₐ(R⁴₂SiO_{2/2})_{b}(R⁴SiO_{3/2})_{c}(SiO_{4/2})_{d}(R⁵O_{1/2})ₑ.

In the formula, each R⁴ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as the R¹ are exemplified. Preferably, R⁴ is a methyl group, a vinyl group, or a phenyl group. Note that at least two of R⁴ are alkenyl groups. In addition, since the hot-melt properties are good, it is preferable that 10 mol% or more, or 20 mol% or more of the total R4 is a phenyl group. Furthermore, in the formula, R⁵ is a hydrogen atom or an alkyl group having 1 to 6 carbon atoms, and the same alkyl groups as those described above are exemplified.

In the formula, a is a number within the range of 0 to 0.7, b is a number within the range of 0 to 0.7, c is a number within the range of 0 to 0.9, d is a number within the range of 0 to 0.7, e is a number within the range of 0 to 0.1, and c+d is a number within the range of 0.3 to 0.9, a+b+c+d is 1, preferably a is a number within the range of 0 to 0.6, b is a number within the range of 0 to 0.6, c is a number within the range of 0 to 0.9, d is a number within the range of 0 to 0.5, e is a number within the range of 0 to 0.05, and c+d is a number within the range of 0.4 to 0.9, a+b+c+d is 1. This is because the hardness and mechanical strength of the obtained cured product are excellent when a, b, and c+d are each a number within the above range.

As component (a₁₋₁), the following organopolysiloxanes are exemplified. In the formulae, Me, Ph, and Vi represent a methyl group, a phenyl group, and a vinyl group, respectively.

(ViMe₂SiO_{1/2})_{0.25}(PhSiO_{3/2})_{0.75}(HO_{1/2})_{0.02}

(ViMe₂SiO_{1/2})_{0.25}(PhSiO_{3/2})₀.₇₅

(ViMe₂SiO_{1/2})_{0.20}(PhSiO_{3/2})_{0.80}

(ViMe₂SiO_{1/2})_{0.15}(Me₃SiO_{1/2})_{0.38}(SiO_{4/2})_{0.47}(HO_{1/2})_{0.01}

(ViMe₂SiO_{1/2})_{0.13}(Me₃SiO_{1/2})_{0.45}(SiO_{4/2})_{0.42}(HO_{1/2})_{0.01}

(ViMe₂SiO_{1/2})_{0.15}(PhSiO_{3/2})_{0.85}(HO_{1/2})_{0.01}

(Me₂SiO_{2/2})_{0.15}(MeViSiO_{2/2})_{0.01}(PhSiO_{3/2})_{0.75}(HO_{1/2})_{0.04}

(MeViPhSiO_{1/2})_{0.20}(PhSiO_{3/2})_{0.80}(HO_{1/2})_{0.05}

(ViMe₂SiO_{1/2})_{0.15}(PhSiO_{3/2})_{0.75}(SiO_{4/2})_{0.10}(HO_{1/2})_{0.02}

(Ph₂SiO_{2/2})_{0.25}(MeViSiO_{2/2})_{0.30}(PhSiO_{3/2})_{0.45}(HO_{1/2})_{0.04}

(Me₃SiO_{1/2})_{0.20}(ViMePhSiO_{1/2})_{0.40}(SiO_{4/2})_{0.40}(HO_{1/2})_{0.08}

Component (a₁₋₂) is polysiloxanes with relatively large amounts of chain siloxane units, and organopolysiloxanes having at least two alkenyl groups in one molecule, expressed by the average unit formula:

(R⁴₃SiO_{1/2})_{a'}(R⁴₂SiO_{2/2})_{b'}(R⁴SiO_{3/2})_{c'}(SiO_{4/2})_{d'}(R⁵O_{1/2})_{e'}.

In the formula, R⁴ and R⁵ are the same groups as described above.

In the formula, a' is a number within the range of 0.01 to 0.3, b' is a number within the range of 0.4 to 0.99, c' is a number within the range of 0 to 0.2, d' is a number within the range of 0 to 0.2, e' is a number within the range of 0 to 0.1, and c'+d' is a number within the range of 0 to 0.2, a'+b'+c'+d' is 1, preferably a' is a number within the range of 0.02 to 0.20, b' is a number within the range of 0.6 to 0.99, c' is a number within the range of 0 to 0.1, d' is a number within the range of 0 to 0.1, e' is a number within the range of 0 to 0.05, and c'+d' is a number within the range of 0 to 0.1, a'+b'+c'+d' is 1. This is because if a', b', c', and d' are each a number within the above range, the obtained cured product can be imparted with toughness.

As component (a₁₋₂), the following organopolysiloxanes are exemplified. In the formulae, Me, Ph, and Vi represent a methyl group, a phenyl group, and a vinyl group, respectively.
ViMe₂SiO(MePhSiO)₁₈SiMe₂Vi, i.e., (ViMe₂SiO_{1/2})_{0.10}(MePhSiO_{2/2})_{0.90} ViMe₂SiO(MePhSiO)₃₀SiMe₂Vi, i.e., (ViMe₂SiO_{1/2})_{0.063}(MePhSiO_{2/2})_{0.937} ViMe₂SiO(MePhSiO)₁₅₀SiMe₂Vi, i.e., (ViMe₂SiO_{1/2})_{0.013}(MePhSiO_{2/2})_{0.987} ViMe₂SiO(Me₂SiO)₁₈SiMe₂Vi, i.e., (ViMe₂SiO_{1/2})_{0.10}(Me₂SiO_{2/2})_{0.90} ViMe₂SiO(Me₂SiO)₃₀SiMe₂Vi, i.e., (ViMe₂SiO_{1/2})_{0.063}(Me2SiO_{2/2})_{0.937} ViMe₂SiO(Me₂SiO)₃₅(MePhSiO)₁₃SiMe₂Vi, i.e., (ViMe₂SiO_{1/2})_{0.04}(Me₂SiO_{2/2})_{0.70}(MePhSiO_{2/2})_{0.26} ViMe₂SiO(Me₂SiO)₁₀SiMe₂Vi, i.e., (ViMe₂SiO_{1/2})_{0.17}(Me₂SiO_{2/2})_{0.83} (ViMe₂SiO_{1/2})_{0.10}(MePhSiO_{2/2})_{0.80}(PhSiO_{3/2})_{0.10}(HO_{1/2})_{0.02} (ViMe₂SiO_{1/2})_{0.20}(MePhSiO_{2/2})_{0.70}(SiO_{4/2})_{0.10}(HO_{1/2})_{0.01} HOMe₂SiO(MeViSiO)₂₀SiMe₂OH
Me₂ViSiO(MePhSiO)₃₀SiMe₂Vi
Me₂ViSiO(Me₂SiO)₁₅₀SiMe2Vi

Component (a₁₋₁) is preferably used from the viewpoint of imparting hardness and mechanical strength to the obtained cured product. Component (a₁₋₂) can be added as an optional component from the viewpoint of imparting toughness to the obtained cured product, but when a crosslinking agent having many chained siloxane units is used in the following component (a₂), it may be used instead. In any case, it is preferable that the mass ratio of the component having a large number of branched siloxane units to the component having a large number of chained siloxane units is within the range of 50:50 to 100:0, or within the range of 60:40 to 100:0. This is because the hardness and mechanical strength of the obtained cured product are good when the mass ratio of the component having a large number of branched siloxane units to the component having a large number of chained siloxane units is within the above range.

When component (a₁) is radically reacted by an organic peroxide, component (a₁₋₁) and component (a₁₋₂) may be reacted within the range of 10:90 to 90:10, and component (a₂) may not be used.

Component (a₂) is a component for crosslinking component (a₁₋₁) and/or component (a₁₋₂) in the hydrosilylation reaction, and is an organopolysiloxane containing at least two silicon atom bonded hydrogen atoms in one molecule. As a group bonded to a silicon atom other than a hydrogen atom in component (a₂), an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, an alkoxy group, an epoxy group-containing group, or a hydroxyl group is exemplified, and the same groups as those described above are exemplified.

Such component (a₂) is not limited, but preferably is an organohydrogenpolysiloxane, represented by the average composition formula:

R⁶ₖHₘSiO_{(4-k-m)/2}.

In the formula, R⁶ is an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, or an aralkyl group having 7 to 20 carbon atoms, and the same groups as the above R¹ are exemplified, and preferably a methyl group or a phenyl group.

In the formula, k is a number in the range of 1.0 to 2.5, preferably in the range of 1.2 to 2.3, m is a number in the range of 0.01 to 0.9, preferably in the range of 0.05 to 0.8, and k+m is a number in the range of 1.5 to 3.0, preferably in the range of 2.0 to 2.7.

Component (a₂) may be a resinous organohydrogenpolysiloxane having a large number of branched siloxane units, or the component may be a chained organohydrogenpolysiloxane having a large number of chained siloxane units. Specifically, examples of component (a₂) include an organohydrogenpolysiloxane represented by the following (a₂₋₁), an organohydrogenpolysiloxane represented by the following (a₂₋₂), or mixtures thereof.

Component (a₂₋₁) is a resinous organohydrogenpolysiloxane having a silicon atom bonded hydrogen atom, expressed by the average unit formula:

[R⁷₃SiO_{1/2}]_{f}[R⁷₂SiO_{2/2}]_{g}[R⁷SiO_{3/2}]ₕ[SiO_{4/2}]ᵢ(R⁵O_{1/2})ⱼ.

In the formula, each R⁷ is independently an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, or a hydrogen atom, and the same groups as the above R¹ are exemplified. Furthermore, in the formula, R⁵ represents a hydrogen atom or an alkyl group having 1 to 6 carbon atoms, and the same groups as described above are exemplified.

In the formula, f is a number within the range of 0 to 0.7, g is a number within the range of 0 to 0.7, h is a number within the range of 0 to 0.9, i is a number within the range of 0 to 0.7, j is a number within the range of 0 to 0.1, and h+i is a number within the range of 0.3 to 0.9, f+g+h+i is 1, preferably f is a number within the range of 0 to 0.6, g is a number within the range of 0 to 0.6, h is a number within the range of 0 to 0.9, i is a number within the range of 0 to 0.5, j is a number within the range of 0 to 0.05, and h+i is a number within the range of 0.4 to 0.9, f+g+h+i+i is 1.

Component (a₂₋₂) is an organopolysiloxane having at least two silicon atom bonded hydrogen atoms in one molecule, expressed by the average unit formula:

(R⁷₃SiO_{1/2})_{f'}(R⁷₂SiO_{2/2})_{g'}(R⁷SiO_{3/2})_{h'}(SiO_{4/2})_{i'}(R⁵O_{1/2})_{j'}.

In the formula, R⁷ and R⁵ are the same groups as described above.

In the formula, f is a number within the range of 0.01 to 0.3, g' is a number within the range of 0.4 to 0.99, h' is a number within the range of 0 to 0.2, i' is a number within the range of 0 to 0.2, j' is a number within the range of 0 to 0.1, and h'+i' is a number within the range of 0 to 0.2, and f'+g'+h'+i' is 1, preferably f' is a number within the range of 0.02 to 0.20, g' is a number within the range of 0.6 to 0.99, h' is a number within the range of 0 to 0.1, i' is a number within the range of 0 to 0.1, j' is a number within the range of 0 to 0.05, and h'+i' is a number within the range of 0 to 0.1, and f'+g'+h'+i' is 1.

As described above, in component (a₂), the resinous organopolysiloxane having many branched siloxane units imparts hardness and mechanical strength to the cured product, and the obtained organopolysiloxane having many chained siloxane units imparts toughness to the cured product, and therefore, it is preferable to appropriately use component (a₂₋₁) and component (a₂₋₂) as component (a₂). Specifically, when the number of branched siloxane units in component (a₁) is small, it is preferable to mainly use component (a₂₋₁) as component (a₂), and when the number of chained siloxane units in component (a₁) is small, it is preferable to mainly use component (a₂₋₂). Component (a₂) preferably has a mass ratio of component (a₂₋₁) to component (a₂₋₂) within the range of 50:50 to 100:0, or within the range of 60:40 to 100:0.

As component (a₂), the following organopolysiloxanes are exemplified. In the formulae, Me and Ph represent a methyl group and a phenyl group, respectively.

Ph₂Si(OSiMe₂H)₂, i.e., Ph_{0.67}Me_{1.33}H_{0.67}SiO_{0.67}

HMe₂SiO(Me₂SiO)₂₀SiMe₂H, i.e., Me_{2.00}H_{0.09}SiO_{0.95}

HMe₂SiO(Me₂SiO)₅₅SiMe₂H, i.e., Me_{2.00}H_{0.04}SiO_{0.98}

PhSi(OSiMe₂H)₃, i.e., Ph_{0.25}Me_{1.50}H_{0.75}SiO_{0.75}

(HMe₂SiO_{1/2})_{0.6}(PhSiO_{3/2})_{0.4}, i.e., Ph_{0.40}Me_{1.20}H_{0.60}SiO_{0.90}

The amount of component (a₂) to be added is such that the molar ratio of silicon atom bonded hydrogen atoms in component (a₂) to the alkenyl groups in component (a₁) is in an amount of 0.2 to 0.7, preferably in an amount of 0.3 to 0.6. This is because the hardness and the mechanical strength of the obtained cured product are good when the amount of component (a₂) to be added is within the above ranges.

The organic peroxide used for radically reacting component (a₁) is not limited, and the organic peroxides exemplified by component (C) below can be used. In the radical reaction, component (a₁) is preferably a mixture of component (a₁₋₁) and component (a₁₋₂) in the mass ratio ranging from 10:90 to 90:10. Although the amount of the organic peroxide to be added is not limited, it is preferably within the range of 0.1 to 5 parts by mass, within the range of 0.2 to 3 parts by mass, or within the range of 0.2 to 1.5 parts by mass, based on 100 parts by mass of component (a₁).

The hydrosilylation reaction catalyst used for the hydrosilylation reaction of component (a₁) and component (a₂) is not limited, and a hydrosilylation reaction catalyst exemplified by component (C) below can be used. The amount of the hydrosilylation reaction catalyst to be added is preferably an amount in which platinum-based metal atoms in the hydrosilylation reaction catalyst are within the range of 0.01 to 500 ppm, within the range of 0.01 to 100 ppm, or within the range of 0.01 to 50 ppm in terms of mass units, with regard to the total amount of component (a₁) and component (a₂).

The above component (A₃) is obtained by condensing the following component (a₃) and the following component (a₄) with a condensation reaction catalyst.

Component (a₃) is a condensation reactive organopolysiloxane, expressed by the average unit formula:

(R⁴₃SiO_{1/2})ₚ(R⁸₂SiO_{2/2})_{q}(R⁸SiO_{3/2})ᵣ(SiO_{4/2})ₛ(R⁹O_{1/2})ₜ.

In the formula, each R⁸ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. Furthermore, in the formula, R⁹ is a hydrogen atom, an alkyl group having 1 to 6 carbon atoms, or an acyl group having 2 to 5 carbon atoms, and an alkoxy group such as a methoxy group or an ethoxy group and an acyloxy group are exemplified. Component (a₃) has at least one silicon atom bonded hydroxyl group, silicon atom bonded alkoxy group, or silicon atom bonded acyloxy group in one molecule. In addition, it is preferable that in one molecule, at least two R⁸ is an alkenyl group, and 10 mol% or more, or 20 mol% or more of the total R⁸ is a phenyl group.

In the formula, p is a number within the range of 0 to 0.7, q is a number within the range of 0 to 0.7, r is a number within the range of 0 to 0.9, s is a number within the range of 0 to 0.7, t is a number within the range of 0.01 to 0.10, and r+s is a number within the range of 0.3 to 0.9, p+q+r+s is 1, and preferably p is a number within the range of 0 to 0.6, q is a number within the range of 0 to 0.6, r is a number within the range of 0 to 0.9, s is a number within the range of 0 to 0.5, t is a number within the range of 0.01 to 0.05, and r+s is a number within the range of 0.4 to 0.9. This is because, when p, q, and r+s are each a number within the above range, a hot-melt silicone having flexibility at 25°C. but non-fluidity, low surface tack, and sufficiently low melt viscosity at high temperature is obtained.

Component (a₄) is a condensation reactive organopolysiloxane, expressed by the average unit formula:

(R⁸₃SiO_{1/2})_{p'}(R⁸₂SiO_{2/2})_{q'}(R⁸₂SiO_{3/2})_{r'}(SiO_{4/2})_{s'}(R⁹O_{1/2})_{t'}.

In the formula, R⁸ and R⁹ are the same groups as described above. Component (a₄) has at least one silicon atom bonded hydroxyl group, silicon atom bonded alkoxy group, or silicon atom bonded acyloxy group in one molecule. In the formula, p' is a number within the range of 0.01 to 0.3, q' is a number within the range of 0.4 to 0.99, r' is a number within the range of 0 to 0.2, s' is a number within the range of 0 to 0.2, t' is a number within the range of 0 to 0.1, and r'+s' is a number within the range of 0 to 0.2, p'+q'+r'+s' is 1, and preferably p' is a number within the range of 0.02 to 0.20, q' is a number within the range of 0.6 to 0.99, r' is a number within the range of 0 to 0.1, s' is a number within the range of 0 to 0.1, t' is a number within the range of 0 to 0.05, and r'+s' is a number within the range of 0 to 0.1. This is because, when p', q', r', and s' are each a number within the above range, a hot-melt silicone having flexibility at 25°C. but non-fluidity, low surface tack, and sufficiently low melt viscosity at high temperature is obtained.

The condensation reaction catalyst for condensation reaction of component (a₃) and component (a₄) is not limited, and examples thereof include organic tin compounds such as dibutyltin dilaurate, dibutyltin diacetate, tin octenate, dibutyltin dioctate, and tin laurate; organic titanium compounds such as tetrabutyl titanate, tetrapropyl titanate, and dibutoxy bis(ethyl acetoacetate); acidic compounds such as hydrochloric acid, sulfuric acid, and dodecylbenzene sulfonic acid; alkaline compounds such as ammonia and sodium hydroxide; amine-based compounds such as 1,8-diazabicyclo[5.4.0]undecene (DBU), 1,4-diazabicyclo[2.2.2]octane (DABCO), and preferably an organic tin compound, and an organic titanium compound.

Component (A₃) is a block copolymer composed of a resinous organosiloxane block and a chained organosiloxane block. Such component (A₃) is preferably comprised of 40 to 90 mol% of disiloxy units of the formula [R¹₂SiO_{2/2]}, 10 to 60 mol% of trisiloxy units of the formula [R¹SiO_{3/2}], and preferably contains 0.5 to 35 mol% of silanol groups [=SiOH]. Here, each R¹ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. At least two R¹ in one molecule is an alkenyl group. Further, component (A₃) is a resinous organosiloxane block copolymer in which the disiloxy unit [R¹₂SiO_{2/2}] forms a linear block having on average 100 to 300 disiloxy units per one linear block; the trisiloxy unit [R¹SiO_{3/2}] forms a non-linear block having a molecular weight of at least 500 g/mol; at least 30% of the non-linear blocks are bonded to each other; each linear block is bonded to at least one non-linear block via a -Si-O-Si- linkage; the resinous organosiloxane block copolymer having a mass-average molecular weight of at least 20000 g/mol, and containing at least one alkenyl group of 0.5 to 4.5 mol%.

Component (A₃) is prepared by condensation reaction of (a₅) a resinous organosiloxane or a resinous organosiloxane block copolymer with (a₆) a chained organosiloxane, and optionally (a₇) a siloxane compound.

Component (a₅) is a resinous organopolysiloxane, expressed by the average unit formula:

[R¹₂R²SiO_{1/2}]ᵢ[R¹R²SiO_{2/2}]ᵢᵢ[R¹SiO_{3/2}]ᵢᵢᵢ[R²SiO_{3/2}]ᵢᵥ[SiO_{4/2}]ᵥ.

In the formula, each R¹ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. In addition, in the formula, each R² is independently an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, or an aralkyl group having 7 to 20 carbon atoms, and the same groups as the R¹ are exemplified.

Also, in the formula, i, ii, iii, iv, and v represent the mole fraction of each siloxy unit, i is a number from 0 to 0.6, ii is a number from 0 to 0.6, iii is a number from 0 to 1, iv is a number from 0 to 1, and v is a number from 0 to 0.6, with the proviso that (ii+iii+iv+v) > 0 and (i+ii+iii+iv+v) ≤ 1. In addition, component (a₅) preferably contains 0 to 35 mol% of a silanol group [=SiOH] in one molecule.

Component (a₆) is a linear organosiloxane expressed by general formula:

R¹_{3-α}(X)_{α}SiO(R¹₂SiO)_{β}Si(X)_{α}R¹_{3-α}.

In the formula, R¹ is the same as described above, and the same groups as described above are exemplified. In addition, in the formula, X is a hydrolyzable group selected from -OR⁵, F, Cl, Br, I, -OC(O)R⁵, -N(R⁵)₂, or-ON=CR⁵₂, wherein R⁵ is a hydrogen atom or an alkyl group having 1 to 6 carbon atoms. Furthermore, in the formula, α is independently 1, 2, or 3, and β is an integer of 50 to 300.

Component (a₇) is a siloxane compound expressed by general formula:

R¹R²₂SiX.

In the formula, R¹, R², and X are the same groups as described above.

The condensation reaction catalyst for condensation reaction of component (a₅) and component (a₆) and/or component (a₇) is not limited, and examples thereof include organic tin compounds such as dibutyltin dilaurate, dibutyltin diacetate, tin octenate, dibutyltin dioctate, and tin laurate; organic titanium compounds such as tetrabutyl titanate, tetrapropyl titanate, and dibutoxy bis(ethyl acetoacetate); acidic compounds such as hydrochloric acid, sulfuric acid, and dodecylbenzene sulfonic acid; alkaline compounds such as ammonia and sodium hydroxide; amine-based compounds such as 1,8-diazabicyclo[5.4.0]undecene (DBU), 1,4-diazabicyclo[2.2.2]octane (DABCO).

Component (A) preferably exhibits hot-melt properties, in particular is non-fluid at 25°C. and preferably has a melt viscosity of less than or equal to 8000 Pa·s at 100°C. Non-fluid refers to not flowing in a no-load condition, for example, the state of being lower than the softening point measured by the softening point testing method in the ball and ring method of hot melt adhesives specified in "Testing methods for the softening point of hot melt adhesives" of JIS K 6863-1994. That is, in order to be non-fluid at 25°C., the softening point must be higher than 25°C.

Component (A) preferably has a melt viscosity at 100°C. of 8000 Pa·s or less, 5000 Pa·s or less, or within the range of 10 to 3000 Pa·s. Moreover, when the melt viscosity at 100°C. is within the abovementioned range, favorable adhesiveness after being hot melted and then cooled at 25°C. is obtained.

As long as component (A) is in the form of fine particles, the particle diameter is not limited, but the average primary particle diameter is preferably within the range of 1 to 5000 µm, within the range of 1 to 500 µm, within the range of 1 to 100 µm, within the range of 1 to 20 µm, or within the range of 1 to 10 µm. The average primary particle diameter can be obtained, for example, by observation with an optical microscope or an SEM. The shape of component (A) is not limited, and a spherical shape, a spindle shape, a plate shape, a needle shape, and an irregular shape are exemplified, and it is preferable to have a spherical shape or a true spherical shape because it melts uniformly. Especially, when component (A) has a true spherical shape of 1 to 10 µm, the melting characteristics and the mechanical properties after curing of the present composition can be satisfactorily improved.

The method for producing component (A) is not limited, and a known method can be used. For example, component (A) is simply atomized, or at least two kinds of organopolysiloxanes are crosslinked and the reactants are atomized simultaneously or separately.

As a method for finely-pulverizing the obtained silicone after crosslinking at least two kinds of organopolysiloxanes, for example, a method of pulverizing the silicone using a pulverizer or a method of directly pulverizing the silicone in the presence of a solvent can be cited. The pulverizer may be, for example, but not limited to, a roll mill, a ball mill, a jet mill, a turbo mill, or a planetary mill. As a method of directly atomizing the silicone in the presence of a solvent, for example, spraying by a spray dryer, or atomization by a biaxial kneader or a belt dryer can be cited. In the present invention, it is particularly preferable to use true spherical hot-melt silicone fine particles obtained by spraying with a spray dryer from the viewpoints of melting characteristics of the granular compound, flexibility of the cured product, improvement of the blending amount and light reflectance of component (B), efficiency in manufacturing and handling workability of the composition.

By using a spray dryer or the like, component (A) having a true spherical shape and an average primary particle diameter of 1 to 500 µm can be produced. The heating and drying temperature of the spray dryer needs to be appropriately set based on the heat resistance of the silicone fine particles and the like. In order to prevent secondary aggregation of the silicone fine particles, it is preferable to control the temperature of the silicone fine particles to be equal to or lower than the glass transition temperature thereof. The silicone fine particles thus obtained can be recovered by a cyclone, a bag filter, or the like.

In order to obtain a uniform component (A), a solvent may be used in the above-mentioned step within the range that does not inhibit the curing reaction. Examples of the solvents include, but are not limited to, aliphatic hydrocarbons such as n-hexane, cyclohexane, and n-heptane; aromatic hydrocarbons such as toluene, xylene, and mesitylene; ethers such as tetrahydrofuran and dipropyl ether; silicones such as hexamethyldisiloxane, octamethyltrisiloxane, and decamethyltetrasiloxane; esters such as ethyl acetate, butyl acetate, and propylene glycol monomethyl ether; and ketones such as acetone, methyl ethyl ketone, and methyl isobutyl ketone.

Component (B) of the present invention is an inorganic filler substantially free of coarse particles having an average particle diameter of 5 µm or more, and by using an inorganic filler smaller than the particle diameter of component (A), it is possible to provide a curable particulate silicone composition which cures to give a cured product which is flexible at a temperature of from room temperature to a high temperature. Further, it is preferable that the curable particulate silicone composition of the present invention has a high light reflectance in the visible light region, and that component (B) contains a white pigment substantially free of coarse particles having an average particle diameter of 5 µm or more, typified by titanium oxide fine particles having an average particle diameter of 0.5 µm or less, as a main component. Here, the term "substantially free of coarse particles having an average particle diameter of 5 µm or more" means that coarse particles having an average particle diameter of 5 µm or more are not observed in the long diameter of the particles when component (B) is observed by an electron microscope or the like, or that the volume ratio of coarse particles having an average particle diameter of 5 µm or more is less than 1% when the particle diameter distribution of component (B) is measured by a laser diffraction scattering type particle size distribution measurement or the like.

Such component (B) is preferably at least one filler which does not have a softening point or does not soften below the softening point of the component (A), and may be a component which improves the handling workability of the composition and imparts mechanical properties and other properties to the cured product of the composition. Examples of component (B) include inorganic fillers, organic fillers, and mixtures thereof, and inorganic fillers are preferable. As the inorganic filler, a reinforcing filler, a white pigment, a thermally conductive filler, a conductive filler, a phosphor, and a mixture of at least two of these are exemplified, and it is preferable to use a white pigment substantially free of coarse particles having an average particle diameter of 5 µm or more as a main component. Examples of the organic filler include a silicone resin filler, a fluorine resin filler, and a polybutadiene resin filler. The shape of these fillers is not particularly limited, and may be spherical, spindle-shaped, flat, needle-shaped, amorphous, or the like.

Since the curable particulate silicone composition of the present invention has a high light reflectance in the visible light region and provides a cured product useful as a light reflecting material, particularly a light reflecting material used for optical semiconductor (LED) applications, the whiteness of the cured product is imparted and the light reflectivity is improved, and therefore, it is preferable that component (B) contains, as a main component, a white pigment substantially free of coarse particles having an average particle diameter of 5 µm or more. Examples of the white pigment include metal oxides such as titanium oxide, aluminum oxide, zinc oxide, zirconium oxide, and magnesium oxide; hollow fillers such as glass balloons and glass beads; and barium sulfate, zinc sulfate, barium titanate, aluminum nitride, boron nitride, and antimony oxide. Titanium oxide is preferred because of its high light reflectivity and opacifying property. In addition, aluminum oxide, zinc oxide, and barium titanate are preferable because of their high light reflectance in the UV region. The white pigment may be surface-treated with a silane coupling agent, silica, aluminum oxide, or the like.

As component (B) used in the curable particulate silicone composition of the present invention, particularly preferably, (B1) fine titanium oxide particles having an average particle diameter of 0.5 µm or less are used, and by highly filling the composition, the cured product is given a high light reflectance and opacifying property in the visible wavelength region, and further, the light reflectance in the visible wavelength region hardly changes when the low wavelength side and the high wavelength side are compared.

Component (B) preferably contains 90 mass% or more, more preferably 95 mass% or more, particularly preferably 98 mass% or more of (B1) titanium oxide fine particles having an average particle diameter of 0.5 µm or less, and most preferably 99 mass% or more of component (B1) and preferably substantially composed of only component (B1).

As described above, it is preferable that component (B) is mainly composed of a white pigment which does not substantially contain coarse particles having an average particle diameter of 5 µm or more; however, when the composition is used in an application such as a sealant, a protective agent, or an adhesive, a reinforcing filler may be blended as component (B) in order to impart mechanical strength to the cured product and improve the protective property or the adhesive property. Examples of the reinforcing filler include fumed silica, precipitated silica, fused silica, calcined silica, fumed titanium dioxide, quartz, calcium carbonate, diatomaceous earth, aluminum oxide, aluminum hydroxide, zinc oxide, and zinc carbonate. These reinforcing fillers may also be surface treated with organoalkoxysilanes such as methyltrimethoxysilane; organohalosilanes such as trimethylchlorosilane; organosilazanes such as hexamethyldisilazane; siloxane oligomers such as α,ω-silanol group- blocked dimethylsiloxane oligomers, α,ω-silanol group-blocked methylphenylsiloxane oligomers, α,ω-silanol group-blocked methylvinylsiloxane oligomers, and the like. The reinforcing filler is substantially free of coarse particles having an average particle diameter of 5 µm or more. Further, as the reinforcing filler, a fibrous filler such as calcium metasilicate, potassium titanate, magnesium sulfate, sepiolite, zonolite, aluminum borate, rock wool, glass fiber, or the like may be used.

As long as component (B) does not substantially contain coarse particles having an average particle diameter of 5 µm or more, the component may contain silicone fine particles which do not correspond to component (A), and the stress relaxation characteristics and the like can be improved or adjusted as desired. Silicone fine particles include non-reactive silicone resin fine particles and silicone elastomer fine particles, but silicone elastomer fine particles are suitably exemplified from the standpoint of improving flexibility or stress relaxation properties.

The silicone elastomer fine particles are a crosslinked product of linear diorganopolysiloxane comprised of primarily of diorganosiloxy units (D-units). The silicone elastomer fine particles can be prepared by a crosslinking reaction of diorganopolysiloxane by a hydrosilylation reaction, a condensation reaction of a silanol group, or the like, and in particular, the silicone elastomer fine particles can be suitably obtained by a crosslinking reaction of organohydrogenpolysiloxane having a silicon bonded hydrogen atom at a side chain or a terminal with diorganopolysiloxane having an unsaturated hydrocarbon group such as an alkenyl group at a side chain or a terminal under a hydrosilylation reaction catalyst. The silicone elastomer fine particles may have various shapes such as spherical, flat, and irregular shapes, but are preferably spherical in terms of dispersibility, and among these, true spherical is more preferable. Commercial products of such silicone elastomer fine particles include, for example, "Torefil-E series" and "EP Powder series" manufactured by Dow Corning Toray Company, Ltd., and "KMP series" manufactured by Shin-Etsu Chemical Co., Ltd.
The silicone elastomer fine particles may be subjected to a surface treatment. Examples of the surface treatment agent include, for example, methylhydrogenpolysiloxane, silicone resin, metal soap, silane coupling agent, inorganic oxide such as silica and titanium oxide, fluorine compound such as perfluoroalkylsilane and perfluoroalkylphosphate ester salt.

When the present composition is used as a wavelength conversion material for an LED, a phosphor may be blended as component (B) to convert the emission wavelength from the optical semiconductor element. The phosphor is not particularly limited as long as it substantially does not contain coarse particles having an average particle diameter of 5 µm or more and examples of the phosphor include yellow, red, green, and blue light phosphors, which include oxide phosphors, oxynitride phosphors, nitride phosphors, sulfide phosphors, oxysulfide phosphors, and the like, which are widely used in light emitting diodes (LED). Examples of the oxide phosphors include yttrium, aluminum, and garnet-type YAG green to yellow light phosphors containing cerium ions; terbium, aluminum, and garnet-type TAG yellow light phosphors containing cerium ions; and silicate green to yellow light phosphors containing cerium or europium ions. In addition, exemplary oxynitride phosphors include silicon, aluminum, oxygen, and nitrogen type SiAION red to green light phosphors containing europium ions. Examples of nitride phosphors include calcium, strontium, aluminum, silicon, and nitrogen-type CASN red light phosphors containing europium ions. Exemplary sulfide phosphors include ZnS green light phosphors containing copper ions or aluminum ions. Exemplary oxysulfide phosphors include Y₂O₂S red light phosphors containing europium ions. In the composition, two or more of these phosphors may be used in combination.

In addition, the composition may contain a thermally conductive filler or a conductive filler to impart thermal or electrical conductivity to the cured product. As the thermally conductive filler or the conductive filler, there are exemplified a metal fine powder such as gold, silver, nickel, copper, aluminum; a fine powder obtained by depositing or plating a metal such as gold, silver, nickel, copper or the like on the surface of a fine powder such as ceramic, glass, quartz, organic resin or the like; a metal compound such as aluminum oxide, magnesium oxide, aluminum nitride, boron nitride, zinc oxide or the like; graphite, and a mixture of two or more of these, as long as they do not substantially contain coarse particles having an average particle diameter of 5 µm or more. When electrical insulation is required for the present composition, a metal oxide-based powder or a metal nitride-based powder is preferable, and in particular, an aluminum oxide powder, a zinc oxide powder, or an aluminum nitride powder is preferable.

While not limited thereto, the content of component (B) is preferably within the range of 10 to 2000 parts by mass, within the range of 10 to 1500 parts by mass, or within the range of 10 to 1000 parts by mass, with regard to 100 parts by mass of component (A). In particular, component (B) of the present invention is substantially free of coarse particles having an average particle diameter of 5 µm or more, and even when it is blended in a relatively large amount relative to component (A), the handling workability of the composition and the gap filling property at the time of hot-melt are not deteriorated, and the obtained cured product has excellent flexibility and mechanical strength at a temperature of from room temperature to a high temperature. Therefore, component (B) is preferably blended in a range of 50 to 900 parts by mass, 100 to 800 parts by mass, and 150 to 750 parts by mass with respect to 100 parts by mass of component (A). Furthermore, the composition of the present invention may contain component (B) in an amount of 50 mass% or more, 60 mass% or more and 70 mass% in total, and in particular, component (B) is preferably component (B1) from the viewpoint of light reflectance.

Component (C) is a curing agent for curing component (A), and is not limited as long as component (A) can be cured. When component (A) has an alkenyl group, component (C) is an organohydrogenpolysiloxane having at least two silicon atom bonded hydrogen atoms in one molecule and a hydrosilylation reaction catalyst, when component (A) contains an alkenyl group and contains a hydrosilylation reaction catalyst, component (C) may be only an organopolysiloxane having at least two silicon atom bonded hydrogen atoms in one molecule, but a hydrosilylation reaction catalyst may be used in combination. In addition, when component (A) has an alkenyl group, component (C) may be an organic peroxide, but an organopolysiloxane having at least two silicon atom bonded hydrogen atoms may be used in combination in one molecule. On the other hand, when component (A) has a silicon atom bonded hydrogen atom, component (C) is an organopolysiloxane having at least two alkenyl groups in one molecule and a hydrosilylation reaction catalyst, when component (A) has a silicon atom bonded hydrogen atom and contains a hydrosilylation reaction catalyst, component (C) may be an organopolysiloxane having at least two alkenyl groups in one molecule, but a hydrosilylation reaction catalyst may be used in combination.

Examples of organopolysiloxanes in component (C) include organopolysiloxanes containing alkenyl groups represented by the above (a₁) and/or the above (a₂), or organopolysiloxanes containing silicon atom bonded hydrogen atoms represented by the above (a₃) and/or the above (a₄).

When an organopolysiloxane is used as component (C), the content thereof is not limited, but for curing the composition, it is preferable that the amount of silicon atom bonded hydrogen atoms is within the range of 0.5 to 20 mol or within the range of 1.0 to 10 mol with regard to 1 mol of alkenyl group in the composition.

As the hydrosilylation reaction catalyst, platinum-based catalysts, rhodium-based catalysts, and palladium-based catalysts are exemplified, and platinum-based catalysts are preferable because the curing of the present composition can be remarkably accelerated. Examples of the platinum-based catalyst include platinum fine powder, chloroplatinic acid, an alcohol solution of chloroplatinic acid, a platinum-alkenyl siloxane complex, a platinum-olefin complex, a platinum-carbonyl complex, and a catalyst in which a platinum-based catalyst is dispersed or encapsulated with a thermoplastic resin such as silicone resin, polycarbonate resin, acrylic resin or the like, with a platinum-alkenyl siloxane complex particularly preferable. Examples of this alkenyl siloxane include: 1,3-divinyl-1,1,3,3-tetramethyldisiloxane; 1,3,5,7-tetramethyl-1,3,5,7-tetravinylcyclotetrasiloxane; an alkenyl siloxane obtained by substituting part of methyl groups of these alkenyl siloxanes with an ethyl group, a phenyl group, etc.; and an alkenyl siloxane obtained by substituting part of vinyl groups of these alkenyl siloxanes with an allyl group, a hexenyl group, etc. In particular, 1,3-divinyl-1,1,3,3-tetramethyldisiloxane is preferable because the platinum-alkenylsiloxane complex has good stability. In addition, a particulate platinum-containing hydrosilylation reaction catalyst dispersed or encapsulated with a thermoplastic resin may be used from the standpoint of improving handling workability and pot life of the composition. As the catalyst for promoting the hydrosilylation reaction, a non-platinum metal catalyst such as iron, ruthenium, iron/cobalt, or the like may be used.

The amount of the hydrosilylation reaction catalyst to be added is preferably an amount in which the metal atom is within the range of 0.01 to 500 ppm, an amount within the range of 0.01 to 100 ppm, or an amount within the range of 0.01 to 50 ppm in terms of mass units with regard to component (A).

Examples of organic peroxide include alkyl peroxides, diacyl peroxides, ester peroxides, and carbonate peroxides.

Examples of alkyl peroxides include dicumyl peroxide, di-tert-butyl peroxide, di-tert-butylcumyl peroxide, 2,5-dimethyl-2,5-di(tert-butylperoxy)hexane, 2,5-dimethyl-2,5-di(tert-butylperoxy)hexyne-3, tert-butylcumyl, 1,3-bis(tert-butylperoxyisopropyl)benzene, and 3,6,9-triethyl-3,6,9-trimethyl-1,4,7-triperoxonan.

Examples of diacyl peroxides include benzoyl peroxide, lauroyl peroxide, and decanoyl peroxide.

Examples of ester peroxides include 1,1,3,3-tetramethylbutylperoxyneodecanoate, α-cumylperoxyneodecanoate, tert-butylperoxyneodecanoate, tert-butylperoxyneoheptanoate, tert-butylperoxypivalate, tert-hexylperoxypivalate, 1,1,3,3-tetramethylbutylperoxy-2-ethylhexanoate, tert-amylperoxyl-2-ethylhexanoate, tert-butylperoxy-2-ethylhexanoate, tert-butylperoxyisobutyrate, di-tert-butylperoxyhexahydroterephthalate, tert-amylperoxy-3,5,5-trimethylhexanoate, tert-butylperoxy-3,5,5-trimethylhexanoate, tert-butylperoxyacetate, tert-butylperoxybenzoate, and dibutylperoxytrimethyladipate.

Examples of carbonate peroxides include di-3-methoxybutyl peroxydicarbonate, di(2-ethylhexyl)peroxydicarbonate, diisopropyl peroxycarbonate, tert-butyl peroxyisopropylcarbonate, di(4-tert-butylcyclohexyl)peroxydicarbonate, dicetyl peroxydicarbonate, and dimyristyl peroxydicarbonate.

The organic peroxide preferably has a 10-hour half-life temperature of 90°C. or more, or 95°C. or more. Examples of such organic peroxide include dicumyl peroxide, di-tert-butyl peroxide, di-tert-hexyl peroxide, tert-butylcumyl peroxide, 2,5-dimethyl-2,5-di(tert-butylperoxy)hexane, 1,3-bis(tert-butylperoxyisopropyl)benzene, di-(2-tert-butylperoxyisopropyl)benzene, and 3,6,9-triethyl-3,6,9-trimethyl-1,4,7-triperoxonan.

While not limited thereto, the content of organic peroxide is preferably within the range of 0.05 to 10 parts by mass, or within the range of 0.10 to 5.0 parts by mass, with regard to 100 parts by mass of component (A).

The present composition may contain a curing retardant or an adhesion imparting agent as other optional components as long as the object of the present invention is not impaired.

Examples of the curing retardant include: alkyne alcohols such as 2-methyl-3-butyne-2-ol, 3,5-dimethyl-1-hexyne-3-ol, 2-phenyl-3-butyne-2-ol, 1-ethynyl-1-cychlohexanol; enyne compounds such as 3-methyl-3-pentene-1-yne, 3,5-dimethyl-3-hexene-1-yne; alkenyl group-containing low molecular weight siloxanes such as tetramethyltetravinylcyclotetrasiloxane and tetramethyltetrahexenylcyclotetrasiloxane; and alkynyloxysilanes such as methyl tris(1,1-dimethyl propynyloxy)silane and vinyl tris(1,1-dimethyl propynyloxy)silane. The content of the curing retardant is not limited, but is preferably within the range of 10 to 10000 ppm in terms of mass units, with regard to the composition.

As the adhesion imparting agent, an organosilicon compound having at least one alkoxy group bonded to a silicon atom in one molecule is preferable. Examples of this alkoxy group include a methoxy group, an ethoxy group, a propoxy group, a butoxy group, and a methoxyethoxy group, with a methoxy group particularly preferable. Moreover, examples of groups other than alkoxy group, bonded to the silicon atom of the organosilicon compound include: halogen substituted or unsubstituted monovalent hydrocarbon groups such as an alkyl group, an alkenyl group, an aryl group, an aralkyl group, and a halogenated alkyl group; glycidoxyalkyl groups such as a 3-glycidoxypropyl group and a 4-glycidoxybutyl group; epoxycyclohexylalkyl groups such as a 2-(3,4-epoxycyclohexyl)ethyl group and a 3-(3,4-epoxycyclohexyl)propyl group; epoxyalkyl groups such as a 3,4-epoxybutyl group and a 7,8-epoxyoctyl group; acryl group-containing monovalent organic groups such as a 3-methacryloxypropyl group; and hydrogen atoms. This organosilicon compound preferably has a group that may react with an alkenyl group or a silicon atom bonded hydrogen atom in this composition, and specifically, preferably has a silicon atom bonded hydrogen atom or an alkenyl group. Moreover, because favorable adhesion can be imparted to various base materials, this organosilicon compound preferably has at least one epoxy group-containing a monovalent organic group per one molecule. Examples of such an organosilicon compound include an organosilane compound, an organosiloxane oligomer, and an alkyl silicate. Examples of the molecular structure of this organosiloxane oligomer or alkyl silicate include a linear structure, a partially branched linear structure, a branched structure, a cyclic structure, and a network structure, with a linear structure, a branched structure, and a network structure particularly preferable. Examples of an organosilicon compound include: silane compounds such as 3-glycidoxypropyltrimethoxysilane, 2-(3,4-epoxycyclohexyl)ethyltrimethoxysilane, and 3-methacryloxypropyltrimethoxysilane; mixtures of siloxane compounds having at least one silicon bonded alkenyl group or silicon bonded hydrogen atom and at least one silicon bonded alkoxy group, silane compounds or siloxane compounds having at least one silicon atom bonded alkoxy group in one molecule and siloxane compounds having at least one silicon atom bonded hydroxy group and at least one silicon atom bonded alkenyl group in one molecule; methylpolysilicate; ethylpolysilicate; and an epoxy group-containing ethylpolysilicate. The adhesion imparting agent is preferably in the form of a low viscosity liquid, and its viscosity is not limited, but it is preferably within the range of 1 to 500 mPa·s at 25°C. In addition, while not limited thereto, the content of this adhesion imparting agent is preferably within the range of 0.01 to 10 parts by mass with regard to 100 parts by mass of the total of the present composition.

Further, as long as the object of the present invention is not impaired, the present composition may contain, as other optional ingredients, at least one liquid organopolysiloxane of the above (a1) to (a4); a heat-resistant agent such as iron oxide (red iron oxide), cerium oxide, cerium dimethylsilanoate, fatty acid cerium salt, cerium hydroxide, and zirconium compounds; a release agent such as carnauba wax, montan wax, calcium stearate, calcium montanate, magnesium stearate, magnesium montanate, zinc stearate, zinc montanate, ester wax, and olefinic wax; and other agents such as dyes, non-white pigments, flame retardants, and the like.

The above composition has excellent characteristics in that the cured product is flexible at a temperature of from room temperature to a high temperature, specifically from 25°C. to 150°C., is excellent in the stress relaxation characteristics, and is hardly damaged even if deformation such as bending occurs at room temperature, by using component (B) substantially free of coarse particles having an average particle diameter of 5 µm or more and component (A) as the hot-melt silicone fine particles in combination. Further, by blending a large amount of a white pigment not containing coarse particles typified by titanium oxide fine particles having an average particle diameter of 0.5 µm or less as component (B), a high light reflectance in the visible light region, in particular, a high light reflectance in the thin film is realized.

Specifically, in the cured product obtained by curing the above composition, the value of the storage modulus (G') at 25°C. is 2000 MPa or less, and the value of the storage modulus (G') at 150°C. is 100 MPa or less.

The above composition is cured to provide a cured product having a high spectral reflectance in the visible light region, and specifically, a cured product having a spectral reflectance of 90% or more, preferably 95% or more, more preferably 97% or more at a wavelength of 450 nm at a thickness of 100 µm is provided. Further, the above cured product preferably has a spectral reflectance of 90% or more, more preferably 95% or more, and still more preferably 97% or more at a wavelength of 700 nm at a thickness of 100 µm.

In particular, the above composition is characterized in that the wavelength dependence of the light reflectance in the visible light region is extremely small by using an inorganic filler as component (B) which is substantially free of coarse particles having an average particle diameter of 5 µm or more and which provides high light reflectance. That is, in the above composition, the light reflectance (ρ₄₅₀) at a wavelength of 450 nm and the light reflectance (ρ₇₀₀) at a wavelength of 700 nm are both 90% or more at a thickness of 100 µm after curing,
A cured product can be provided in which the respective light reflectance differences, expressed as (ρ₇₀₀/ρ₄₅₀)^{∗}100(%), are less than 10%, preferably less than 5%, more preferably less than 3%.

The present composition may be used in pellet form. The pellets of the present composition are obtained by compression molding the present composition, and are excellent in handling workability and curability. The "pellet" may also be referred to as a "tablet". The shape of the pellet is not limited, but is usually spherical, elliptical spherical, or cylindrical. The size of the pellet is not limited, and for example, the pellet has an average particle diameter or a circle equivalent diameter of 500 µm or more.

The composition may be molded into a sheet and used. For example, a sheet made of a curable particulate silicone composition having an average thickness of 500 µm or more, preferably several mm, has hot-melt properties and heat-curable properties at a high temperature, and therefore is advantageous in terms of excellent handling workability and excellent melting characteristics, particularly when used for compression molding or the like.

The composition is non-fluid at 25°C. Here, the term "non-fluid" means that it is not deformed or flowed in a no-load condition, and it is preferable that it is not deformed or flowed in a no-load condition at 25°C. when it is molded into a pellet, a tablet, or the like. Such non-fluid can be evaluated, for example, by placing a molded product of the composition on a hot plate at 25°C. and substantially not deforming or flowing under no load or constant weight. This is because, when non-fluid at 25°C., shape retention at this temperature is good and the surface tackiness is low.

The softening point of the composition is preferably 100°C. or less. Such a softening point means a temperature at which the deformation amount in the height direction is 1 mm or more when the deformation amount of the composition is measured after the load is removed by continuing to press the hot plate with a load of 100 grams for 10 seconds from above.

The composition preferably has a melt viscosity at 100°C. of 8000 Pa·s or less, 6000 Pa·s or less, or 5000 Pa·s or less. The melt viscosity at 100°C. is preferably 10 Pa·s or more. This is because the adhesiveness to the base material after the composition is hot-melted and then cooled to 25°C. is good. The melt viscosity referred to herein can be measured at a shear rate of 5[1/s] by a rheometer AR2000EX (manufactured by T.A. Instruments Japan, Inc.) or the like.

The composition has excellent curing characteristics. The curing characteristics of the composition can be evaluated using a rheometer. The curing characteristics of the present composition can be evaluated based on the values of T₁ and T₉₀ for the times (seconds) at which the 1% torque value and the 90% torque value are obtained, respectively, when the torque value after 3 minutes at a constant temperature of 150 to 180°C. is set to 100. The present composition preferably has the T₁ of 20 seconds or more, or 25 seconds or more, as measured at a constant temperature of 150 to 180°C. In addition, the composition preferably has the T₉₀ of 145 seconds or less, or 140 seconds or less, as measured at a temperature of 150 to 180°C. The rheometer used for the measurements is exemplified by a rheometer MDR2000 (manufactured by Alpha Technologies, Inc.).

### Method of producing curable particulate silicone composition

The present composition can be produced by powder-mixing components (A) to (C) and other optional components at a temperature lower than the softening point of component (A). The powder mixer used in the present manufacturing method is not limited, and exemplified are a uniaxial or biaxial continuous mixer, a two-roll mixer, a Ross mixer, a Hobart mixer, a dental mixer, a planetary mixer, a kneader mixer, a laboratory mixer, a small-sized mill, and a henschel mixer, and preferably, a laboratory mixer, a small-sized mill, and a henschel mixer.

### Method of molding cured porduct

The composition can be cured by a method comprising at least the following steps (I) to (III).
(I) a step of heating and melting the present composition to the softening point of component (A) or higher;
(II) a step of injecting the curable silicone composition obtained in step (I) into a mold or a step of distributing the curable silicone composition obtained in step (I) to a mold by clamping; and
(III) a step of curing the curable silicone composition injected in step (II).

In the above steps, a transfer molding machine, a compression molding machine, an injection molding machine, an auxiliary ram molding machine, a slide molding machine, a double ram molding machine, a low pressure sealing molding machine, or the like can be used. In particular, the composition of the present invention can be suitably used for the purpose of obtaining a cured product by transfer molding and compression molding.

Finally, in step (III), the curable silicone composition injected (applied) in step (II) is cured. When an organic peroxide is used as component (C), the heating temperature is preferably 150°C. or higher or 170°C. or higher.

Since it is suitable as a protective member for a semiconductor or the like, the cured product obtained by curing the present composition preferably has a type-D durometer hardness of 40 or more or 50 or more at 25°C. This type-D durometer hardness is determined by the type-D durometer in accordance with the JIS K 6253-1997 "Hardness Testing Methods for Vulcanized Rubber and Thermoplastic Rubber".

### Use of composition

Since the composition has hot-melt properties and excellent handling workability and curing properties, it is suitable as a sealing agent and an underfill agent for semiconductors; a sealing agent and an underfill agent for power semiconductors such as SiC and GaN; a sealing agent and a light reflecting material for optical semiconductors such as light emitting diodes, photodiodes, phototransistors, and laser diodes; an adhesive for electricity and electronics, a potting agent, a protective agent, and a coating agent. Since the composition has hot-melt properties, it is also suitable as a material for transfer molding, compression molding, or injection molding. In particular, a sheet obtained by molding the composition of the present invention is useful as a material for compression molding.

### Use of cured product

The use of the cured product of the present invention is not particularly limited, but the composition of the present invention has hot-melt properties, is excellent in moldability and gap fill properties, and the cured product has flexibility at room temperature, high stress relaxation properties, bending strength, and high light reflectance as described above. Therefore, the cured product obtained by curing the present composition can be suitably used as a light reflecting material, particularly, a light reflecting material of an optical semiconductor device.

The optical semiconductor device provided with the light reflecting material made of the cured product of the present invention is not particularly limited, but it is particularly preferable to be a chip scale package type optical semiconductor device in which the wall thickness of the light reflecting material is thin.

### EXAMPLES

The curable particulate liquid silicone composition of the present invention, and the production method thereof are described below in further detail using examples and comparative examples. Note that in the formulae, Me, Ph, and Vi represent a methyl group, a phenyl group, and a vinyl group, respectively. Further, with respect to the curable silicone compositions of Examples and Comparative Examples, the softening point, melt viscosity, moldability, warpage of the molded product, and storage modulus and total luminous reflectance of the cured product were measured as follows, and the results are shown in Table 1.

### Softening point of hot-melt silicone

The hot-melt silicone was placed on a hot plate set at 25°C. to 100°C., and the liquefied temperature was used as the softening point while checking the state with a spatula.

### Softening point of curable particulate silicone composition

The curable particulate silicone composition was molded into cylindrical pellets of ϕ14 mm^{∗}22 mm. The pellet was placed on a hot plate set at 25°C. to 100°C. and kept pressed from above for 10 seconds with a load of 100 grams, and after the load was removed, the amount of deformation of the pellet was measured. The temperature at which the deformation amount in the height direction was 1 mm or more was defined as the softening point.

### Melt viscosity

The melt viscosities of the hot-melt silicone and curable particulate silicone compositions at 100°C. were measured at a shear rate of 5(1/s) using a rheometerAR2000EX (manufactured by T.A. Instruments Japan K.K.).

### Moldability and Warpage of Molded Product

The curable particulate silicone composition was integrally molded with a lead frame made of copper using a transfer molding machine to produce a molded product having a length of 35 mm, a width of 25 mm, a height of 1 mm. As molding conditions, in Examples 1 to 5, Example 7, and Comparative Examples 1 to 4, the mold temperature was 150°C. and the mold clamping time was 120 seconds, and in Example 6 (peroxide curing), the mold temperature was 180°C. and the mold clamping time was 120 seconds. After the molded product was taken out from the mold, it was cooled to 25°C., and then the presence or absence of cracks and the presence or absence of molding defects such as peeling from the lead frame were visually confirmed. In addition, one side of the lead frame after molding was fixed to a horizontal desk with a tape, and the lift distance from the desk on the other side was measured using a ruler, and the warp value of the molded product was obtained.

### Storage modulus of cured product

The curable particulate silicone composition was heated at 150°C. for 2 hours to prepare a cured product. The storage modulus of the cured product from -50°C. to 250°C. was measured using a rheometer ARES (manufactured by T.A. Instrument Japan Co., Ltd.) and the values at 25°C. and 150°C. were read.

### Spectral Reflectance of Cured Product

The curable particulate silicone composition was heated at 150°C. for 2 hours to prepare a 100 µm thick cured product. The spectral reflectance of the cured product was measured using a UV-VIS spectrophotometer UV3100PC (manufactured by Shimadzu Corporation), and the spectral reflectance at wavelengths of 450 nm and 700 nm was read.

### Reference Example 1

In a 1-L flask, 270.5 g of a 55 mass% toluene solution of a resinous organopolysiloxane represented by the average unit formula: (PhSiO_{3/2})0.80(Me₂ViSiO_{1/2})_{0.20}, which is a white solid at 25°C.; 21.3 g of a diphenylsiloxane in which both ends of the molecular chain were blocked with dimethylhydrogensiloxy groups and which has a viscosity of 5 mPa·s (content of silicon atom bonded hydrogen atoms = 0.6 mass%) represented by the formula: HMe₂SiO(Ph₂SiO)SiMe₂H (at an amount such that the amount of silicon atom bonded hydrogen atoms in this component is 0.5 mol with regard to 1 mol of vinyl groups in the resinous organopolysiloxane); and 0.034 g of a 1,3-divinyltetramethyldisiloxane solution of platinum 1,3-divinyltetramethyldisiloxane complex (content of platinum metal = about 4000 ppm) (at an amount such that platinum metal becomes 10 ppm in terms of mass units with regard to the liquid mixture) were charged, and stirred uniformly at room temperature.

Thereafter, the temperature in the flask was raised to 100°C. by an oil bath, and the mixture was stirred under a reflux of toluene for 2 hours to prepare a toluene solution of an organosiloxane crosslinked product (1) containing a resinous organosiloxane derived from the above-mentioned resinous organopolysiloxane and a chained organosiloxane derived from the above-mentioned diphenylsiloxane and having a vinyl group not involved in the above-mentioned reaction. When the organosiloxane crosslinked product (1) was analyzed by FT-IR, peaks of silicon atom bonded hydrogen atom were not observed. The organosiloxane crosslinked product (1) had a softening point of 75°C. and a melt viscosity of 700 Pa·s at 100°C.

### Reference Example 2

Into a 500 mL four-necked round bottom flask equipped with a thermometer, a Teflon (registered trademark) stirring blade, and a Dean-Stark apparatus connected to a water-cooled condenser and previously filled with toluene, 318.6 g of a 56.5 mass% -toluene solution of an organopolysiloxane represented by the average unit formula: (PhSiO_{3/2})ₙ (wherein n is a positive number such that the weight average molecular weight of the present organopolysiloxane is 1500) was charged under a nitrogen atmosphere.

The mixture was heated at the reflux temperature of toluene for 30 minutes to remove 0.54 g of water. Next, the mixture was cooled to 108°C., and 224.24 g of a methylphenylpolysiloxane mixture obtained by reacting 4.24 g (0.0187 mol) of a mixture of methyltriacetoxysilane/ethyltriacetoxysilane in a molar ratio of 1: 1 and 220 g (1.614 mol) of methylphenylpolysiloxane in which both ends of the molecular chain were blocked with silanol groups (Degree of polymerization = 181) in advance at room temperature for 1 hour was added thereto. The reaction mixture was heated in a nitrogen atmosphere at the reflux temperature of toluene for 2 hours to further remove 2.01 g of water. Thereafter, the reaction solution was again cooled to 108°C., 11.91 g (0.0633 mol) of vinylmethyldiacetoxysilane was added and heated at the reflux temperature of toluene for another one hour to remove 1.05 g of water. The reaction mixture was cooled to 90°C. and 47.8 g of deionized water was added, after which water was removed by azeotropic distillation. The reaction solution was again cooled to 108°C., 21.57 g (0.0949 mol) of a mixture of methyltriacetoxysilane/ethyltriacetoxysilane in a molar ratio of 1: 1 was added and after refluxing for 1 hour, the reaction mixture was cooled to 90°C., 47.8 g of deionized water was added, and water was further removed by azeotropic distillation at reflux (the procedure of removing water by adding such water was repeated twice). The same water treatment was repeated three times, finally, at 118°C., 103.6 g of volatile matter was removed by distillation, and the solid content of the reaction solution was adjusted to about 70 mass%. The obtained product was found to be an organosiloxane block copolymer composed of a resinous organosiloxane block containing 2 mol% vinyl groups and a linear organosiloxane block. The softening point of this organosiloxane block copolymer (2) was 85°C., and its melt viscosity at 100°C. was 2800 Pa s.

Next, to 292 g of the solution of this organosiloxane block copolymer having a solid content concentration of 50 mass%, 0.034 g of a 1,3-divinyltetramethyldisiloxane solution of platinum 1,3-divinyltetramethyldisiloxane complex (content of platinum metal = about 4000 ppm) (at an amount such that platinum metal becomes 10 ppm in terms of mass units with regard to the liquid mixture) was added and uniformly stirred at room temperature (25°C.) to prepare a toluene solution of an organosiloxane block copolymer (2) containing a platinum catalyst.

### Reference Example 3

In a 1-L flask, 270.5 g of a 55 mass% toluene solution of a resinous organopolysiloxane represented by the average unit formula: (PhSiO_{3/2})_{0.80}(Me₂ViSiO_{1/2})_{0.20}, which is a white solid at 25°C.; and 0.034 g of a 1,3-divinyltetramethyldisiloxane solution of platinum 1,3-divinyltetramethyldisiloxane complex (content of platinum metal = about 4000 ppm) were charged, and stirred uniformly at room temperature (25°C.) to prepare a toluene solution of a resinous organopolysiloxane (3) containing platinum metal as mass unit of 10 ppm.

The softening point of this resinous organopolysiloxane (3) was 100°C., and its melt viscosity at 100°C. was 100 Pa s.

### Reference Example 4

Spherical hot-melt silicone fine particles (1) were prepared by atomizing the toluene solution of the organosiloxane crosslinked product (1) prepared in Reference Example 1 by spray drying at 40°C. while removing toluene. Observation of the fine particles with an optical microscope revealed that the particle diameter was 5 to 10 µm and the average particle diameter was 7.5 µm.

### Reference Example 5

The toluene solution of the organosiloxane crosslinked product (1) prepared in Reference Example 1 was charged into a twin-screw kneader heated to 150°C., toluene was removed, and the resultant organosiloxane crosslinked product (1) was pulverized by a ball mill while cooling to prepare hot-melt silicone fine particles (2) of irregular shape. Observation of the fine particles with an optical microscope revealed that the particle diameter was 1000 to 3000 µm and the average particle diameter was 1500 µm.

### Reference Example 6

Spherical hot-melt silicone fine particles (3) were prepared by atomizing the toluene solution of the organosiloxane block copolymer (2) prepared in Reference Example 2 by spray drying at 40°C. while removing toluene. Observation of the fine particles with an optical microscope revealed that the particle diameter was 5 to 10 µm and the average particle diameter was 6.5 µm.

### Reference Example 7

Spherical hot-melt silicone fine particles (4) were prepared by atomizing the toluene solution of the resinous organopolysiloxane (3) prepared in Reference Example 3 by spray drying at 40°C. while removing toluene. Observation of the fine particles with an optical microscope revealed that the particle diameter was 5 to 10 µm and the average particle diameter was 7.9 µm.

### Example 1

89.3 g of hot-melt silicone fine particles (1), 10.7 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%) {at an amount such that the amount of silicon atom bonded hydrogen atoms in the above diphenylsiloxane is 1.0 mol with regard to 1 mol of vinyl groups in the silicone fine particles (1)}, 1-ethynyl -1-cyclohexanol (at an amount of 300 ppm in terms of mass units with regard to the present composition), 302.2 g of titanium oxide (CR-93 manufactured by Ishihara Sangyo Kaisha, Ltd.) having an average particle diameter of 0.28 µm, and 1.3 g of fumed silica (AEROSIL 50 manufactured by Nippon Aerosil Co., Ltd.) having an average particle diameter of 0.04 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Example 2

74.1 g of hot-melt silicone fine particles (1), 11.1 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 14.8 g of methylphenylpolysiloxane in which both ends of the molecular chain were blocked with dimethylvinylsiloxy groups and which has a viscosity of 1,000 mPa·s, represented by the average formula: Me₂ViSiO(MePhSiO)_{17.5}SiMe₂Vi (content of vinyl groups = 2.1 mass%) {at an amount such that the amount of silicon atom bonded hydrogen atoms in the above diphenylsiloxane is 1.0 mol with regard to 1 mol of vinyl groups in the silicone fine particles (1) and the methylphenylpolysiloxane in which both ends of the molecular chain were blocked with dimethylvinylsiloxy groups}, 1-ethynyl-1-cyclohexanol (at an amount of 300 ppm in terms of mass units with regard to the present composition), 297.6 g of titanium oxide (SX-3103 manufactured by Sakai Chemical Industry Co., Ltd.) having an average particle diameter of 0.5 µm, and 2.4 g of fumed silica (AEROSIL 50 manufactured by Nippon Aerosil Co., Ltd.) having an average particle diameter of 0.04 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Example 3

90.9 g of hot-melt silicone fine particles (3), 4.5 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 4.5 g of branched chain organopolysiloxane having 2 or more silicon atom bonded hydrogen atoms in one molecule and a viscosity of 25 mPa·s, represented by the average unit formula: (PhSiO_{3/2})_{0.4}(HMe₂SiO_{1/2})_{0.6} (content of silicon atom bonded hydrogen atoms = 0.65 mass%) {at an amount such that the amount of silicon atom bonded hydrogen atoms in the above diphenylsiloxane and the above organopolysiloxane is 1.0 mol with regard to 1 mol of vinyl groups in the silicone fine particles (3)}, and 300.0 g of titanium oxide (CR-93 manufactured by Ishihara Sangyo Kaisha, Ltd.) having an average particle diameter of 0.28 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Example 4

86.2 g of hot-melt silicone fine particles (3), 5.2 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 4.3 g of branched chain organopolysiloxane having 2 or more silicon atom bonded hydrogen atoms in one molecule and a viscosity of 25 mPa·s, represented by the average unit formula: (PhSiO_{3/2})_{0.4}(HMe₂SiO_{1/2})_{0.6} (content of silicon atom bonded hydrogen atoms = 0.65 mass%), 4.3 g of methylphenylpolysiloxane in which both ends of the molecular chain were blocked with dimethylvinylsiloxy groups and which has a viscosity of 1,000 mPa·s, represented by the average formula: Me₂ViSiO(MePhSiO)_{17.5}SiMe₂Vi (content of vinyl groups = 2.1 mass%) {at an amount such that the amount of silicon atom bonded hydrogen atoms in the above diphenylsiloxane and the above organopolysiloxane is 1.0 mol with regard to 1 mol of vinyl groups in the silicone fine particles (3) and the methylphenylpolysiloxane in which both ends of the molecular chain were blocked with dimethylvinylsiloxy groups}, and 297.4 g of titanium oxide (SX-3103 manufactured by Sakai Chemical Industry Co., Ltd.) having an average particle diameter of 0.5 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Example 5

78.1 g of hot-melt silicone fine particles (4), 21.9 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), the average unit formula: {at an amount such that the amount of silicon atom bonded hydrogen atoms in the above diphenylsiloxane is 1.0 mol with regard to 1 mol of vinyl groups in the silicone fine particles (5)}, and 296.9 g of titanium oxide (SX-3103 manufactured by Sakai Chemical Industry Co., Ltd.) having an average particle diameter of 0.5 µm, and 4.3 g of fumed silica (AEROSIL 50 manufactured by Nippon Aerosil Co., Ltd.) having an average particle diameter of 0.04 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Example 6

66.7 g of hot-melt silicone fine particles (1), 33.3 g of methylphenylpolysiloxane in which both ends of the molecular chain were blocked with dimethylvinylsiloxy groups, represented by the average formula: Me₂ViSiO(MePhSiO)_{17.5}SiMe₂Vi (content of vinyl groups = 2.1 mass%), 1.7 g of 2,5-dimethyl-2,5-di(tert-butylperoxy)hexane (having a 10-hour half-life temperature of 118°C.), and 233.3 g of titanium oxide (CR-93 manufactured by Ishihara Sangyo Kaisha, Ltd.) having an average particle diameter of 0.28 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Example 7

89.3 g of hot-melt silicone fine particles (2), 10.7 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%) {at an amount such that the amount of silicon atom bonded hydrogen atoms in the above diphenylsiloxane is 1.0 mol with regard to 1 mol of vinyl groups in the silicone fine particles (1)}, 1-ethynyl-1-cyclohexanol (at an amount of 300 ppm in terms of mass units with regard to the present composition), 302.2 g of titanium oxide (CR-93 manufactured by Ishihara Sangyo Kaisha, Ltd.) having an average particle diameter of 0.28 µm, and 1.3 g of fumed silica (AEROSIL 50 manufactured by Nippon Aerosil Co., Ltd.) having an average particle diameter of 0.04 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Comparative Example 1

89.3 g of hot-melt silicone fine particles (1), 10.7 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%) {at an amount such that the amount of silicon atom bonded hydrogen atoms in the component is 1.0 mol with regard to 1 mol of vinyl groups in the above silicone fine particles (2)}, 1-ethynyl-1-cyclohexanol (at an amount of 300 ppm in terms of mass units with regard to the present composition), 192.0 g of a spherical silica having an average particle diameter of 15 µm (HS-202 manufactured by Nippon Steel & Sumikin Materials Co., Ltd., Micron Co.), 156.3 g of titanium oxide (SX-3103 manufactured by Sakai Chemical Industry Co., Ltd.) having an average particle diameter of 0.5 µm, and 53.6 g of glass fiber (EFDE 50-01 manufactured by Central Glass Co., Ltd.) with a fiber diameter of 6 µm and fiber length of 50 µm were introduced into a small-sized mill at once, and stirring was performed for 1 minute at room temperature (25°C) to prepare a uniform and white curable particulate silicone composition.

Next, this composition was tableted by a tableting machine to prepare cylindrical pellets having a diameter of 14 mm and a height of 22 mm.

### Comparative Example 2

68.2 g of methylvinylphenylpolysiloxane represented by the average unit formula: (MeViSiO_{2/2})_{0.25}(Ph₂SiO_{2/2})_{0.30}(PhSiO_{3/2})_{0.45}(HO_{1/2})_{0.02}, 9.1 g of a dimethylvinylsiloxy-terminated polymethylphenylsiloxane represented by the average formula: ViMe₂SiO(MePhSiO)_{17.5}SiViMe₂, 22.7 g of 1,1,5,5-tetramethyl-3,3-diphenyltrisiloxane represented by the formula: (HMe₂SiO)₂SiPh₂ (at an amount such that the amount of silicon atom bonded hydrogen atoms in this component is 1.15 mol with regard to 1 mol of total vinyl groups in the above-mentioned methylvinylphenylpolysiloxane and dimethylvinylsiloxy-terminated polymethylphenylsiloxane), a 1,3-divinyl-1,1,3,3-tetramethyldisiloxane solution of platinum 1,3-divinyl-1,1,3,3-tetramethyldisiloxane complex (at an amount such that platinum metal becomes 5.0 ppm in terms of mass units with regard to the present composition), 1-ethynyl-1-cyclohexanol (at an amount of 300 ppm in terms of mass units with regard to the present composition), 83.2 g of titanium oxide (SX-3103 manufactured by Sakai Chemical Industry Co., Ltd.) having an average primary particle diameter of 0.2 µm, and 150 g of crushed quartz powder having an average particle diameter of 5 µm (Crystalite VX-52 manufactured by Tatsumori Ltd.) were blended to prepare a pasty curable silicone composition having a viscosity at 25°C. of 410 Pa·s.

When this composition was heated at 120°C. for 10 minutes, the resulting product was a solid whose viscosity could not be measured at 25°C. and had hot-melt properties to fluidize when heated to 100°C. or higher. This composition was fluidized at 100°C. or higher and then heated at 150°C. for 10 minutes, whereupon the hot meltability was lost. This composition was poured into a Teflon (registered trademark) tube having a diameter of 14 mm and heated at 120°C. for 10 minutes to prepare cyrindrical pellets having a height of 22 mm.

### Comparative Example 3

24.2 g of methylvinylpolysiloxane in which both ends of the molecular chain were blocked with hydroxyl groups and which has a linear methylvinylsiloxane block represented by the formula: -(MeViSiO_{2/2})₆-, 22.5 g of dimethylpolysiloxane in which both ends of the molecular chain were blocked with dimethylvinylsiloxy groups, represented by the formula: Me₂ViSiO(Me₂SiO)₄₆SiMe₂Vi, 357.1 g of titanium oxide (SX-3103 manufactured by Sakai Chemical Industry Co., Ltd.) having an average primary particle diameter of 0.2 µm, 93.4 g of a spherical silica having an average particle diameter of 15 µm (HS-202 manufactured by Nippon Steel & Sumikin Materials Co., Ltd., Micron Co.), 11.0 g of n-octyltriethoxysilane, and 11.0 g of dimethylpolysiloxane in which one end of the molecular chain was blocked with a trimethylsiloxy group and another end of the molecular chain was blocked with a trimethoxysiloxy group and which has a viscosity of 125 mPa·s, represented by the formula: Me₃SiO(Me₂SiO)₁₁₀Si(OMe)₃ were charged in a Ross mixer, mixed at room temperature, and kneaded while heating at 150°C. under reduced pressure to prepare a silicone base.

Next, at room temperature, to the silicone base, 22.5 g of methylhydrogenpolysiloxane in which both ends of the molecular chain were blocked with trimethylsiloxy groups and which has a linear methylhydrogensiloxane block represented by the formula: -(MeHSiO_{2/2})₅₀- (at an amount such that the amount of silicon atom bonded hydrogen atoms in this component is 1.5 mol with regard to 1 mol of total of the vinyl groups in methylvinylpolysiloxane of the silicone base and the vinyl groups of dimethylpolysiloxane in which both ends of the molecular chain were blocked with dimethylvinylsiloxy groups), 5.5 g of a condensation reaction product of dimethylsiloxane-methylvinylsiloxane copolymerization oligomer (in which both ends of the molecular chain were blocked with hydroxyl groups) and 3-glycidoxypropyltrimethoxysilane at a mass ratio of 1: 2, which has a viscosity of 20 mPa·s, and 1-ethynyl-1-cyclohexanol (at an amount of 200 ppm in terms of mass units with regard to the present composition) were blended, a 1,3-divinyl-1,1,3,3-tetramethyldisiloxane solution of platinum 1,3-divinyl-1,1,3,3-tetramethyldisiloxane (at an amount such that platinum metal becomes 3 ppm in terms of mass units with regard to the present composition) was further blended to prepare a pasty curable silicone composition having a viscosity of 510 Pa·s at 25°C.

### Comparative Example 4

55.2 g of methylvinylphenylpolysiloxane represented by the average unit formula: (MeViSiO_{2/2})_{0.15}(Me₂SiO_{2/2})_{0.15}(Ph₂SiO_{2/2})_{0.30}(PhSiO_{3/2})_{0.40}(HO_{1/2})_{0.04}, 13.8 g of 1,3,5,7-tetramethyl-1,3,5,7-tetravinylcyclotetrasiloxane represented by the formula: (MeViSiO)₄, 30.9 g of 1,1,5,5-tetramethyl-3,3-diphenyltrisiloxane represented by the formula: (HMe₂SiO)₂SiPh₂ (at an amount such that the amount of silicon atom bonded hydrogen atoms in this component is 0.9 mol with regard to 1 mol of total vinyl groups in the above-mentioned methylvinylphenylpolysiloxane and 1,3,5,7-tetramethyl-1,3,5,7-tetravinylcyclotetrasiloxane), a 1,3-divinyl-1,1,3,3,-tetramethyldisiloxane solution of platinum 1,3-divinyl-1,1,3,3,-tetramethyldisiloxane (at an amount such that platinum metal becomes 3.5 ppm in terms of mass units with regard to the present composition), 1-ethynyl-1-cyclohexanol (at an amount of 200 ppm in terms of mass units with regard to the present composition), 55.2 g of titanium oxide (SX-3103 manufactured by Sakai Chemical Industry Co., Ltd.) having an average primary particle diameter of 0.2 µm, 74.6 g of crushed quartz powder having an average particle diameter of 5 µm (Crystalite VX-52 manufactured by Tatsumori Ltd.), and 60.8 g of a spherical silica having an average particle diameter of 15 µm (HS-202 manufactured by Nippon Steel & Sumikin Materials Co., Ltd., Micron Co.) were blended to prepare a pasty curable silicone composition having a viscosity of 39 Pa·s.

**Table 1**

| Example No. | Example 1 | Example 2 | Example 3 | Example 4 | Example 5 | |
|---|---|---|---|---|---|---|
| Properties of curable liquid silicone composition Softening point (°C.) | 60 | 60 | 55 | 50 | 80 | |
| Melt viscosity (Pa·s) | 2840 | 1560 | 3860 | 3340 | 1350 | |
| Moldability | Favorable | Favorable | Favorable | Favorable | Favorable | |
| Properties of Cured Product Storage modulus at 25°C. (MPa) | 1620 | 940 | 1240 | 870 | 1840 | |
| Storage modulus at 150°C. (MPa) | 74 | 31 | 56 | 28 | 89 | |
| Warpage of Molded Product (mm) | <1 | <1 | <1 | <1 | <1 | |
| Spectral reflectance at 450 nm (%) | 99.2 | 99.4 | 98.9 | 99.0 | 99.2 | |
| Spectral reflectance at 700 nm (%) | 98.0 | 98.1 | 97.5 | 98.3 | 98.3 | |

| Example No. | Example 6 | Example 7 | Comparative Example 1 | Comparative Example 2 | Comparative Example 3 | Comparative Example 4 |
|---|---|---|---|---|---|---|
| Properties of curable liquid silicone composition Softening point (°C.) | 60 | 60 | 60 | 55 | N/A | N/A |
| Melt viscosity (Pa·s) | 3190 | 3990 | 1450 | 830 | N/A | N/A |
| Moldability | Favorable | Favorable | Favorable | Favorable | Crack | Peeling |
| Properties of Cured Product Storage modulus at 25°C. (MPa) | 1870 | 1730 | 4740 | 1940 | 1340 | 1540 |
| Storage modulus at 150°C. (MPa) | 44 | 95 | 384 | 22 | 980 | 190 |
| Warpage of Molded Product (mm) | <1 | <1 | 3 | <1 | 4 | 2 |
| Spectral reflectance at 450 nm (%) | 98.4 | 98.1 | 91.9 | 90.5 | 99.1 | 92.3 |
| Spectral reflectance at 700 nm (%) | 97.2 | 96.4 | 88.3 | 87.1 | 96.2 | 89.4 |

## Claims

1. A curable particulate silicone composition, comprising:
(A) hot-melt silicone fine particles having a softening point of 30°C. or higher and having a hydrosilylation reactive group and/or a radical reactive group;
(B) an inorganic filler substantially free of coarse particles having an average particle diameter of 5 µm or more; and
(C) a curing agent,
wherein when cured, the curable particulate silicone composition provides a cured product that has:
a storage modulus (G') at 25°C. of 2000 MPa or less, and
a storage modulus (G') at 150°C. of 100 MPa or less, and
a spectral reflectance of 90% or more at a wavelength of 450 nm at a thickness of 100 µm.

2. The curable particulate silicone composition according to claim 1, wherein component (B) is a filler that does not have a softening point or does not soften below the softening point of component (A).

3. The curable particulate silicone composition according to claim 1 or 2, wherein 90 mass% or more of component (B) is (B1) titanium oxide fine particles having an average particle diameter of 0.5 µm or less.

4. The curable particulate silicone composition according to any one of claims 1 to 3, wherein component (B) consists essentially of (B1) titanium oxide fine particles having an average particle diameter of 0.5 µm or less.

5. The curable particulate silicone composition according to claim 1, wherein component (A) is silicone fine particles comprising (A₁) a resinous organopolysiloxane, (A₂) an organopolysiloxane crosslinked product obtained by partially crosslinking at least one organopolysiloxane, (A₃) a block copolymer composed of a resinous organosiloxane block and a chained organosiloxane block, or a mixture of at least two of these.

6. The curable particulate silicone composition according to claim 1 or 5, wherein component (A) is true-spherical silicone fine particles in which 10 mol % or more of the silicon atom-bonded organic groups in component (A) is an aryl group and the average primary particle diameter thereof is 1 to 10 µm.

7. The curable particulate silicone composition according to claim 1, wherein the amount of component (B) is 10 to 2000 parts by mass with regard to 100 parts by mass of component (A).

8. The curable particulate silicone composition according to any one of claims 1 to 7, which provides a cured product having a spectral reflectance of 90% or more at a wavelength of 700 nm at a thickness of 100 µm.

9. The curable particulate silicone composition according to any one of claims 1 to 8, wherein the curable particulate silicone composition is in the form of pellets or sheets.

10. A cured product formed by curing the curable particulate silicone composition according to any one of claims 1 to 9.

11. The cured product according to claim 10, wherein the light reflectance (ρ₄₅₀) at a wavelength of 450 nm and the light reflectance (ρ₇₀₀) at a wavelength of 700 nm at a thickness of 100 µm are both 90% or more, and
the differences in the respective light reflectance expressed as (ρ₇₀₀/ρ₄₅₀)^{∗}100(%) are less than 10%.

12. Use of the cured product according to claim 10 or 11 as a light reflecting material.

13. An optical semiconductor device comprising a cured product of the curable silicone composition according to any one of claims 1 to 9 as a light reflecting material.

14. The optical semiconductor device according to claim 13, which is a chip scale package type optical semiconductor device.

15. A method of molding a cured product, comprising at least the following steps (I) to (III):
(I) a step of heating and melting the curable particulate silicone composition according to any one of claims 1 to 9 to the softening point of component (A) or higher;
(II) a step of injecting the curable silicone composition obtained in step (I) into a mold or a step of distributing the curable silicone composition obtained in step (I) to a mold by clamping; and
(III) a step of curing the curable silicone composition injected in step (II).
